# EUROPEAN PATENT APPLICATION

(11) **EP 2 339 405 A1**
(43) Date of publication of application: **29.06.2011**
(21) Application number: 10196451.8
(22) Date of filing: 22.12.2010
(51) Int. Cl.: G03F 7/32, B41C 1/00

(54) **Method of preparing lithographic printing plate**

(30) Priority: 25.12.2009 JP 2009296419
(71) Applicant: Fujifilm Corporation, Minato-ku Tokyo 106-0031 (JP)
(72) Inventor: Inno, Toshifumi, Shizuoka (JP)
(74) Representative: HOFFMANN EITLE

(57) **Abstract**

A plate-making method includes: exposing a lithographic printing plate precursor with laser; and rubbing a surface of the exposed lithographic printing plate precursor with a rubbing member in the presence of a developer having pH of from 2 to 11 and containing a water-soluble polymer compound to remove the protective layer and an unexposed area of the photosensitive layer, the lithographic printing plate precursor includes, in the following order, a hydrophilic support, a photosensitive layer containing a polymerization initiator, a polymerizable compound, a sensitizing dye and a binder polymer and a protective layer, and the water-soluble polymer compound is a vinyl copolymer containing a monomer unit having at least one functional group capable of interacting with a surface of the support and a monomer unit having at least one hydrophilic group which is different from the functional group capable of interacting with a surface of the support.

## Description

### FIELD OF THE INVENTION

The present invention relates to a method of preparing a lithographic printing plate, particularly, to a method of preparing a lithographic printing plate which enables conducting a simple processing which does not require a water washing step.

### BACKGROUND OF THE INVENTION

In general, a lithographic printing plate is composed of an oleophilic image area accepting ink and a hydrophilic non-image area accepting dampening water in the process of printing. Lithographic printing is a printing method which comprises rendering the oleophilic image area of the lithographic printing plate to an ink-receptive area and the hydrophilic non-image area thereof to a dampening water-receptive area (ink unreceptive area), thereby making a difference in adherence of ink on the surface of the lithographic printing plate, and depositing the ink only on the image area by utilizing the nature of water and printing ink to repel with each other, and then transferring the ink to a printing material, for example, paper.

In order to prepare the lithographic printing plate, a lithographic printing plate precursor (PS plate) comprising a hydrophilic support having provided thereon an oleophilic photosensitive resin layer (also referred to as a photosensitive layer or an image-recording layer) has heretofore been broadly used. Ordinarily, the lithographic printing plate is obtained by conducting plate making according to a method of exposing the lithographic printing plate precursor through an original, for example, a lith film, and then removing the unnecessary portion of the image-recording layer by dissolving with an alkaline developer or an organic solvent thereby revealing the hydrophilic surface of support to form the non-image area while leaving the image-recording layer in the portion for forming the image area.

In recent years, digitalized technique of electronically processing, accumulating and outputting image information using a computer has been popularized, and various new image outputting systems responding to the digitalized technique have been put into practical use. Correspondingly, attention has been drawn to a computer-to-plate (CTP) technique of carrying digitalized image information on highly converging radiation, for example, laser light and conducting scanning exposure of a lithographic printing plate precursor with the light thereby directly preparing a lithographic printing plate without using a lith film. Thus, it is one of important technical subjects to obtain a lithographic printing plate precursor adaptable to the technique described above.

Further, in the hitherto known plate making process of lithographic printing plate precursor, after exposure, the step of removing the unnecessary portion of the image-recording layer by dissolving, for example, with a developer is required. However, in view of the environment and safety, a processing with a developer closer to a neutral range and a small amount of waste liquid are problems to be solved. Particularly, since disposal of waste liquid discharged accompanying the wet treatment has become a great concern throughout the field of industry in view of the consideration for global environment in recent years, the demand for the resolution of the above-described problems has been increased more and more.

As described above, the decrease in alkali concentration of developer and the simplification of processing step have been further strongly required from both aspects of the consideration for global environment and the adaptation for space saving and low running cost. However, since hitherto known development processing comprises three steps of developing with an aqueous strong alkali solution having pH of more than 11, washing of the alkali agent with a water-washing bath and then treating with a gum solution mainly comprising a hydrophilic resin as described above, an automatic developing machine per se requires a large space and problems of the environment and running cost, for example, disposal of the development waste liquid, water-washing waste liquid and gum waste liquid still remain.

In response to the above situation, for instance, a developing method of processing with a developer having pH of 8.5 to 11.5 and a dielectric constant of 3 to 30 mS/cm and containing an alkali metal carbonate and an alkali metal hydrogen carbonate is proposed in JP-A-11-65126 (the term "JP-A" as used herein means an "unexamined published Japanese patent application"). However, since the developing method is required a water-washing step and a treatment step with a gum solution, it does not resolve the problems of the environment and running cost.

Also, a processing with a processing solution having pH of 11.9 to 12.1 and containing a water-soluble polymer compound is described in the example of EP-A-1868036. However, since the lithographic printing plate obtained by the processing is left in the state that the alkali of pH 12 adheres on the surface thereof, a problem in view of safety of an operator arises and also another problem occurs in that with the lapse of long time after the preparation of the lithographic printing plate until the initiation of printing, the image area gradually dissolves to result in deterioration in printing durability or ink-receptive property. In JP-T-2007-538279 (the term "JP-T" as used herein means a published Japanese translation of a PCT patent application), a processing with a processing solution having pH of 3 to 9 and containing a water-soluble polymer compound is described. However, since the processing solution does not contain a basic component, it is necessary to enable development by making a polymer used in the photosensitive layer hydrophilic and thus, a problem occurs in that printing durability severely degrades. Further, in any cases the hydrophilic protection of the non-image area with a water-soluble polymer compound is insufficient and as increase in the number of printed materials, a satin preventing property of the non-image area tends to degrade.

### SUMMARY OF THE INVENTION

An object of the present invention is to provide a method of preparing a lithographic printing plate which enables to conduct a simple processing of one solution and one step which does not require a water washing step, exhibits good developing property without residue of the photosensitive layer in the non-image area and provides a lithographic printing plate having good printing durability and excellent in an satin preventing property of the non-image area.

The above-described object can be achieved by the construction described below.
(1) A method of preparing a lithographic printing plate comprising exposing a lithographic printing plate precursor comprising a hydrophilic support, a photosensitive layer containing (A) a polymerization initiator, (B) a polymerizable compound, (C) a sensitizing dye and (D) a binder polymer and a protective layer in this order with laser and rubbing a surface of the exposed lithographic printing plate precursor with a rubbing member in the presence of a developer having pH of 2 to 11 and containing a water-soluble polymer compound to remove the protective layer and an unexposed area of the photosensitive layer, wherein the water-soluble polymer compound is a vinyl copolymer containing a monomer unit having at least one functional group capable of interacting with a surface of the support and a monomer unit having at least one hydrophilic group which is different from the functional group capable of interacting with a surface of the support.
(2) The method of preparing a lithographic printing plate as described in (1) above, wherein the functional group capable of interacting with a surface of the support is at least one group selected from an onium group, a phosphoric ester group and a salt thereof, a phosphonic acid group and a salt thereof, a boric acid group and a salt thereof and a β-diketone group.
(3) The method of preparing a lithographic printing plate as described in (1) or (2) above, wherein the hydrophilic group is at least one group selected from a sulfonic acid group and a salt thereof, an amido group, a polyalkyleneoxy group and a group having a betaine structure.
(4) The method of preparing a lithographic printing plate as described in any one of (1) to (3) above, wherein a content ratio of the monomer unit having a functional group capable of interacting with a surface of the support is from 2 to 70% by mole based on a total monomer unit contained in the copolymer.
(5) The method of preparing a lithographic printing plate as described in any one of (1) to (4) above, wherein a content ratio of the monomer unit having a hydrophilic group is from 30 to 98% by mole based on a total monomer unit contained in the copolymer.
(6) The method of preparing a lithographic printing plate as described in any one of (1) to (5) above, wherein a content of the copolymer contained in the developer is from 0.1 to 20% by weight.
(7) The method of preparing a lithographic printing plate as described in any one of (1) to (6) above, wherein the developer further contains a carbonate ion and a hydrogen carbonate ion.
(8) The method of preparing a lithographic printing plate as described in any one of (1) to (6) above, wherein the developer further contains a water-soluble amine compound and an ion of the amine compound.
(9) The method of preparing a lithographic printing plate as described in any one of (1) to (8) above, wherein the developer further contains a surfactant in an amount from 0.01 to 20% by weight.
(10) The method of preparing a lithographic printing plate as described in any one of (1) to (9) above, wherein a water washing step is not contained.
(11) A developer for use in a method of preparing a lithographic printing plate comprising exposing a lithographic printing plate precursor comprising a hydrophilic support, a photosensitive layer containing (A) a polymerization initiator, (B) a polymerizable compound, (C) a sensitizing dye and (D) a binder polymer and a protective layer in this order with laser and removing the protective layer and an unexposed area of the photosensitive layer in the presence of a developer having pH of 2 to 11 and containing a water-soluble polymer compound, wherein the water-soluble polymer compound is a vinyl copolymer containing a monomer unit having at least one functional group capable of interacting with a surface of the support and a monomer unit having at least one hydrophilic group which is different from the functional group capable of interacting with a surface of the support.

According to the present invention, a method of preparing a lithographic printing plate which enables to conduct a simple processing of one solution and one step which does not require a water washing step and exhibits good developing property without residue of the photosensitive layer in the non-image area can be provided. Also, according to the method of preparing a lithographic printing plate of the invention, a lithographic printing plate having good printing durability and excellent in an satin preventing property of the non-image area can be obtained.

### BRIEF DESCRIPTION OF THE DRAWINGS

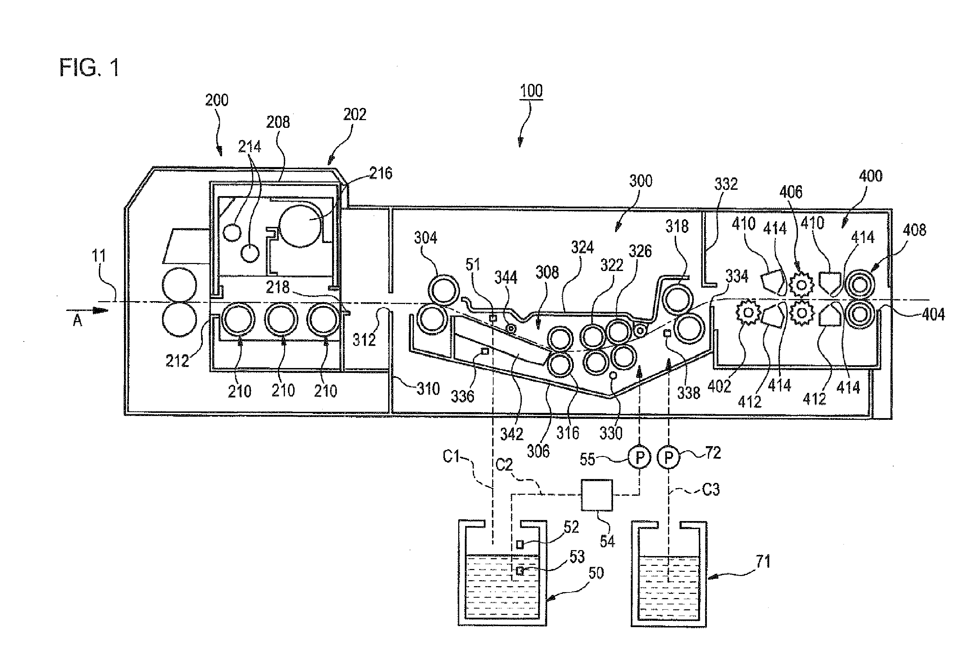

Fig. 1 is an illustration showing a structure of an automatic development processor.

### [Description of reference numerals and signs]

11: Transporting path of lithographic printing plate precursor
200: Pre-heating unit
300: Developing unit
400: Drying unit
202: Machine casing
208: Heating chamber
210: Skewer roller
212: Transporting inlet
214: Heater
216: Circulation fan
304: Insertion roller pair
306: Processing tank
308: Developing tank
310: Outer panel
312: Slit type insertion slot
316: Submerged roller pair
318: Carrying-out roller pair
322: Brush roller pair
324: Shielding cover
326: Brush roller pair
330: Spray pipe
334: Slit type path-through slot
336: Liquid temperature sensor
338: Liquid level meter
332: Partition board
342: Guide member
344: Guide roller
402: Support roller
404: Discharge slot
406: Transport roller pair
408: Transport roller pair
410: Duct
412: Duct
414: Slit hole
50: External tank
51: Overflow aperture
52: Upper limit liquid level meter
53: Lower limit liquid level meter
54: Filter unit
55: Developer supply pump
C1: First circulation pipeline
C2: Second circulation pipeline
71: Water tank for replenishment
72: Water-replenishing pump
C3: Third circulation pipeline

### DETAILED DESCRIPTION OF THE INVENTION

The method of preparing a lithographic printing plate according to the invention comprises exposing a lithographic printing plate precursor comprising a hydrophilic support, a photosensitive layer containing (A) a polymerization initiator, (B) a polymerizable compound, (C) a sensitizing dye and (D) a binder polymer and a protective layer with laser and rubbing a surface of the exposed lithographic printing plate precursor with a rubbing member in the presence of a developer having pH of 2 to 11 and containing a water-soluble polymer compound to remove the protective layer and an unexposed area of the photosensitive layer, wherein the water-soluble polymer compound is a vinyl copolymer containing a monomer unit having at least one functional group capable of interacting with a surface of the support and a monomer unit having at least one hydrophilic group.

The invention has one feature in that the developer contains the vinyl copolymer (hereinafter, also referred to as a water-soluble polymer compound of specific structure) containing a monomer unit having at least one functional group capable of interacting with a surface of the support and a monomer unit having at least one hydrophilic group.

Since the water-soluble polymer compound of specific structure according to the invention has a functional group capable of interacting with (adsorbing to) a surface of the support and a hydrophilic group in the molecule thereof, the non-image area of the photosensitive layer is removed by development processing and onto the surface of support corresponding to the non-image area exposed to the developer, the polymer compound adsorbs to increase the hydrophilicity of the non-image area. Also, since the polymer compound adsorbed is strongly adheres onto the surface of support, it does not leave from the surface of support also during printing to enable to maintain the hydrophilicity.

First, the lithographic printing plate precursor for use in the method of preparing a lithographic printing plate according to the invention is described below.

### [Lithographic printing plate precursor]

The lithographic printing plate precursor according to the invention comprises a hydrophilic support, a photosensitive layer containing (A) a polymerization initiator, (B) a polymerizable compound, (C) a sensitizing dye and (D) a binder polymer and a protective layer in this order (The term "in this order" does not exclude the possibility that there other layer may be provided between the hydrophilic support and the photosensitive layer or between the photosensitive layer and the protective layer.).

### (A) Polymerization initiator

The photosensitive layer contains a polymerization initiator (hereinafter, also referred to as an initiator compound). In the invention, a radical polymerization initiator is preferably used.

As the initiator compound, initiator compounds known to those skilled in the art can be used without limitation. Specifically, the initiator compound includes, for example, a trihalomethyl compound, a carbonyl compound, an organic peroxide, an azo compound, an azide compound, a metallocene compound, a hexaarylbiimidazole compound, an organic boron compound, a disulfone compound, an oxime ester compound, an onium salt compound and a iron arene complex. Among them, at least one compound selected from the hexaarylbiimidazole compound, onium salt compound, trihalomethyl compound and metallocene compound is preferred, and the hexaarylbiimidazole compound is particularly preferred. Two or more kinds of the polymerization initiator may be appropriately used in combination.

The hexaarylbiimidazole compound includes, for example, lophine dimers described in European Patent 24,629, European Patent 10,7792 and US Patent 4,410,621 specifically, 2,2' -bis(o-chlorophenyl)-4 ,4' ,5,5' -tetraphenylbiimidazole,
2,2' -bis(o-bromophenyl)-4,4',5 ,5'-tetraphenylbiimídazole,
2,2'-bis(o,p-dichlorophenyl)-4,4',5,5'-tetraphenylbiimidazole,
2,2'-bis(o-chlorophenyl)-4,4',5,5'-tetra(m-methoxyphenyl)biimidazole, 2,2'-bis(o,o'-dichlorophenyl)-4,4',5,5'-tetraphenylbiimidazole,
2,2'-bis(o-mtrophenyl)-4,4',5,5'-tetraphenylbiimidazole,
2,2' -bis(o-methylphenyl)-4,4' ,5,5' -tetraphenylbiimidazole and
2,2' -bis(o-trifluoromethylphenyl)-4,4' ,5 ,5' -tetraphenylbiimidazole.

The hexaarylbiimidazole compound is particularly preferably used together with the sensitizing dye having an absorption maximum in a wavelength range from 300 to 450 nm described above.

The onium salt compound preferably used in the invention includes a sulfonium salt, an iodonium salt and a diazonium salt. Particularly, a diaryliodonium salt or a triarylsulfonium salt is preferably used.

The onium salt compound is particularly preferably used together with the infrared absorbing agent having an absorption maximum in a wavelength range from 750 to 1,400 nm described above.

In addition, polymerization initiators described in Paragraph Nos. [0071] to [0129] of JP-A-2007-206217 are preferably used.

The polymerization initiators are preferably used individually or in combination of two or more thereof.

The amount of the polymerization initiator used in the photosensitive layer is preferably from 0.01 to 20% by weight, more preferably from 0.1 to 15% by weight, still more preferably from 1.0 to 10% by weight, based on the total solid content of the photosensitive layer.

### (B) Polymerizable compound

The polymerizable compound for use in the photosensitive layer is an addition-polymerizable compound having at least one ethylenically unsaturated double bond and it is selected from compounds having at least one, preferably two or more, terminal ethylenically unsaturated double bonds. The polymerizable compound has a chemical form, for example, a monomer, a prepolymer, specifically, a dimer, a trimer or an oligomer, or a mixture thereof. Examples of the monomer include unsaturated carboxylic acids (for example, acrylic acid, methacrylic acid, itaconic acid, crotonic acid, isocrotonic acid or maleic acid) and esters or amides thereof Preferably, esters of an unsaturated carboxylic acid with a polyhydric alcohol compound and amides of an unsaturated carboxylic acid with a polyvalent amine compound are used. An addition reaction product of an unsaturated carboxylic acid ester or amide having a nucleophilic substituent, for example, a hydroxy group, an amino group or a mercapto group, with a monofunctional or polyfunctional isocyanate or epoxy compound, or a dehydration condensation reaction product of the unsaturated carboxylic acid ester or amide with a monofunctional or polyfunctional carboxylic acid is also preferably used. Moreover, an addition reaction product of an unsaturated carboxylic acid ester or amide having an electrophilic substituent, for example, an isocyanate group or an epoxy group, with a monofunctional or polyfunctional alcohol, amine or thiol, or a substitution reaction product of an unsaturated carboxylic acid ester or amide having a releasable substituent, for example, a halogen atom or a tosyloxy group with a monofunctional or polyfunctional alcohol, amine or thiol is also preferably used. In addition, as other examples, compounds in which the unsaturated carboxylic acid described above is replaced by an unsaturated phosphonic acid, styrene, vinyl ether or the like can also be used. These are described, for examples, in JP-T-2006-508380, JP-A-2002-287344, JP-A-2008-256850, JP-A-2001-342222, JP-A-9-179296, JP-A-9-179297, JP-A-9-179298, JP-A-2004-294935, JP-A-2006-243493, JP-A-2002-275129, JP-A-2003-64130, JP-A-2003-280187 and JP-A-10-333321.

Specific examples of the monomer, which is an ester of a polyhydric alcohol compound with an unsaturated carboxylic acid, include, as an acrylic acid ester, for example, ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraacrylate, sorbitol triacrylate, isocyanuric acid ethylene oxide (EO) modified triacrylate and polyester acrylate oligomer. As a methacrylic acid ester, for example, tetramethylene glycol dimethacrylate, neopentyl glycol dimethacrylate, trimethylolpropane trimethacrylate, ethylene glycol dimethacrylate, pentaerythritol trimethacrylate, bis[p-(3-methacryloxy-2-hydroxypropoxy)phenyl]dimethylmethane and bis[p-(methacryloxyethoxy)phenyljdimethylmethane are exemplified. Specific examples of the monomer, which is an amide of a polyvalent amine compound with an unsaturated carboxylic acid, include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide.

Urethane type addition-polymerizable compounds produced using an addition reaction between an isocyanate and a hydroxy group are also preferably used and specific examples thereof include vinylurethane compounds having two or more polymerizable vinyl groups per molecule obtained by adding a vinyl monomer containing a hydroxy group represented by formula (A) shown below to a polyisocyanate compound having two or more isocyanate groups per molecule, described in JP-B-48-41708 (the term "JP-B" as used herein means an "examined Japanese patent publication").

CH₂₌C(R₄)COOCH₂CH(R₅)OH (A)

wherein R₄ and R₅ each independently represents H or CH₃.

Also, urethane acrylates described in JP-A-51-37193, JP-B-2-32293, JP-B-2-16765, JP-A-2033-344997 and JP-A-2006-65210, urethane compounds having an ethylene oxide skeleton described in JP-B-58-49860, JP-B-56-17654, JP-B-62-39417, JP-B-62-39418, JP-A-2000-250211 and JP-A-2007-94138, and urethane compounds having a hydrophilic group described in US Patent 7,153,632, JP-T-8-505958, JP-A-2007-293221 and JP-A-2007-293223 are preferably used.

Also, a photo-oxidizable Polymerizable compound described in JP-T-2007-506125 is preferred and a polymerizable compound containing at least one urea group and/or tertiary amino group is particularly preferred. Specifically, the compound set forth below is exemplified.

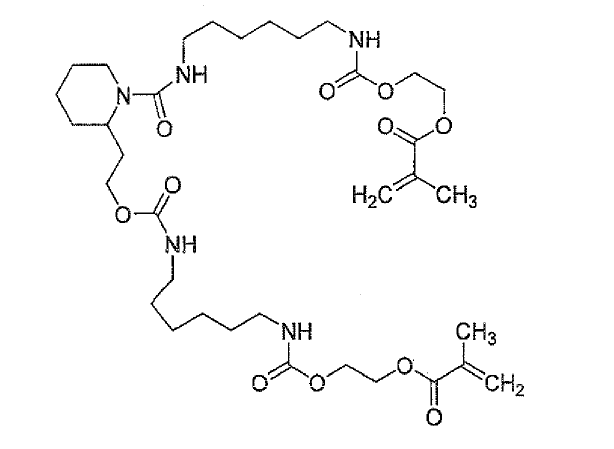

Details of the method of using the Polymerizable compound, for example, selection of the structure, individual or combination use or an amount added, can be appropriately determined in accordance with the characteristic design of the final lithographic printing plate precursor. The polymerizable compound is used preferably in a range from 5 to 75% by weight, more preferably in a range from 25 to 70% by weight, particularly preferably in a range from 30 to 60% by weight, based on the total solid content of the photosensitive layer.

### (C) Sensitizing dye

The photosensitive layer contains a sensitizing dye. The sensitizing dye is not particularly restricted as far as it absorbs light at the image exposure to form the excited state and provides energy to a polymerization initiator with electron transfer, energy transfer or heat generation thereby improving the polymerization initiation function. Particularly, a sensitizing dye having an absorption maximum in a wavelength range from 300 to 450 nm or from 750 to 1,400 nm is preferably used.

Examples of the sensitizing dye having an absorption maximum in a wavelength range from 300 to 450 nm include merocyanines, benzopyranes, coumarins, aromatic ketones, anthracenes, styryls and oxazoles.

Of the sensitizing dyes having an absorption maximum in a wavelength range from 300 to 450 nm, a dye represented by formula (IX) shown below is more preferred in view of high sensitivity.

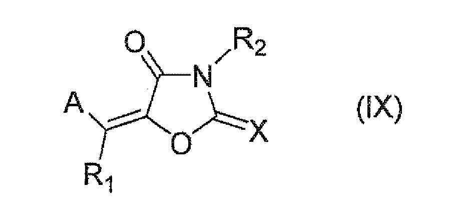

In formula (IX), A represents anaryl group which may have a substituent or a heteroaryl group which may have a substituent, X represents an oxygen atom, a sulfur atom or =N(R₃), and R₁, R₂ and R₃ each independently represents a monovalent non-metallic atomic group, or A and R₁, or R₂ and R₃ may be combined with each other to form an aliphatic or aromatic ring.

The formula (IX) will be described in more detail below. R₁, R₂ and R₃ each independently represents a monovalent non-metallic atomic group, preferably a hydrogen atom, a substituted or unsubstituted alkyl group, a substituted or unsubstituted alkenyl group, a substituted or unsubstituted aryl group, a substituted or unsubstituted heteroaryl group, a substituted or unsubstituted alkoxy group, a substituted or unsubstituted alkylthio group, a hydroxy group or a halogen atom.

The aryl group which may have a substituent and heteroaryl group which may have a substituent represented by A in formula (IX) are same as the substituted or unsubstituted aryl group and substituted or unsubstituted heteroaryl group described for any one of R₁, R₂ and R₃, respectively.

Specific examples of the sensitizing dye preferably used include compounds described in Paragraph Nos. [0047] to [0053] of JP-A-2007-58170, Paragraph Nos. [0036] to [0037] of JP-A-2007-93866 and Paragraph Nos. [0042] to [0047] of JP-A-2007-72816.

Further, sensitizing dyes described in JP-A-2006-189604, JP-A-2007-171406, JP-A-2007-206216, JP-A-2007-206217, JP-A-2007-225701, JP-A-2007-225702, JP-A-2007-316582 and JP-A-2007-328243 are also preferably used.

Next, the sensitizing dye having an absorption maximum in a wavelength range from 750 to 1,400 (hereinafter, also referred to as an "infrared absorbing agent") is described below. The infrared absorbing agent used is preferably a dye or a pigment.

As the dye, commercially available dyes and known dyes described in literatures, for example, Senryo Binran (Dye Handbook) compiled by The Society of Synthetic Organic Chemistry, Japan (1970) can be used. Specifically, the dyes includes azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts and metal thiolate complexes.

Of the dyes, cyanine dyes, squarylium dyes, pyrylium dyes, nickel thiolate complexes and indolenine cyanine dyes are particularly preferred. Further, cyanine dyes and indolenine cyanine dyes are more preferred. As particularly preferable examples of the dye, cyanine dyes represented by formula (a) shown below are exemplified.

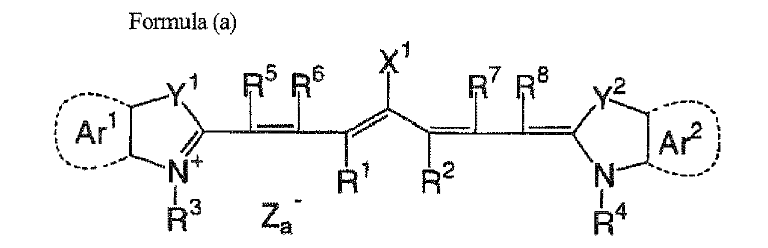

In formula (a), X¹ represents a hydrogen atom, a halogen atom, -NPh₂, -X²-L¹ or a group shown below. X² represents an oxygen atom, a nitrogen atom or a sulfur atom, L¹ represents a hydrocarbon group having from 1 to 12 carbon atoms, an aryl group containing a hetero atom (a nitrogen atom, a sulfur atom, an oxygen atom, a halogen atom or a selenium atom) or a hydrocarbon group having from 1 to 12 carbon atoms and containing a hetero atom. Xa has the same meaning as Za defined hereinafter. R^{a} represents a hydrogen atom or a substituent selected from an alkyl group, an aryl group, a substituted or unsubstituted amino group and a halogen atom.

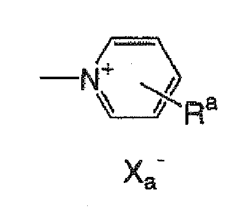

R¹ and R² each independently represents a hydrocarbon group having from 1 to 12 carbon atoms. In view of the preservation stability of a coating solution for photosensitive layer, it is preferred that R¹ and R² each represent a hydrocarbon group having two or more carbon atoms. Also, R¹ and R² may be combined with each other to form a ring and in case of forming the ring, to form a 5-membered or 6-membered ring is particularly preferred.

Ar¹ and Ar², which may be the same or different, each represents an aryl group which may have a substituent. Preferable examples of the aryl group include a benzene ring group and a naphthalene ring group. Preferable examples of the substituent include a hydrocarbon group having 12 or less carbon atoms, a halogen atom and an alkoxy group having 12 or less carbon atoms. Y¹ and Y², which may be the same or different, each represents a sulfur atom or a dialkylmethylene group having 12 or less carbon atoms. R³ and R⁴, which may be the same or different, each represents a hydrocarbon group having 20 or less carbon atoms, which may have a substituent. Preferable examples of the substituent include an alkoxy group having 12 or less carbon atoms, a carboxyl group and a sulfo group. R⁵, R⁶, R⁷ and R⁸, which may be the same or different, each represents a hydrogen atom or a hydrocarbon group having 12 or less carbon atoms. From the standpoint of the availability of raw materials, a hydrogen atom is preferred. Za represents a counter anion. However, Za is not necessary when the cyanine dye represented by formula (a) has an anionic substituent in the structure thereof and the neutralization of charge is not needed. Preferable examples of the counter ion for Za⁻ include a halide ion, a perchlorate ion, a tetrafluoroborate ion, a hexafluorophosphate ion and a sulfonate ion, and particularly preferable examples thereof include a perchlorate ion, a hexafluorophosphate ion and an arylsulfonate ion in view of the preservation stability of a coating solution for photosensitive layer.

Specific examples of the cyanine dye represented by formula (a) which can be preferably used in the invention include compounds described in Paragraph Nos. [0017] to [0019] of JP-A-2001-133969, Paragraph Nos. [0016] to [0021] of JP-A-2002-23360 and Paragraph Nos. [0012] to [0037] of JP-A-2002-40638, preferably compounds described in Paragraph Nos. [0034] to [0041] of JP-A-2002-278057 and Paragraph Nos. [0080] to [0086] of JP-A-2008-195018, and particularly preferably compounds described in Paragraph Nos. [0035] to [0043] of JP-A-2007-90850.

Also, compounds described in Paragraph Nos. [0008] to [0009] of JP-A-5-5005 and Paragraph Nos. [0022] to [0025] of JP-A -2001-22210 are preferably used.

The infrared absorbing dyes may be used individually or in combination of two or more thereof and may be used together with an infrared absorbing agent other than the infrared absorbing dye, for example, a pigment As the pigment, compounds described in Paragraph Nos. [0072] to [0076] of JP-A-2008-195018 are preferred.

The amount of the sensitizing dye added is preferably from 0.05 to 30 parts by weight, more preferably from 0.1 to 20 parts by weight, particularly preferably from 0.2 to 10 parts by weight, per 100 parts by weight of the total solid content of the photosensitive layer.

### (D) Binder polymer

The photosensitive layer contains a binder polymer. As the binder polymer, a polymer capable of holding the components of photosensitive layer on a support and capable of being removed with a developer is used. The binder polymer used includes a (meth)acrylic polymer, a polyurethane resin, a polyvinyl alcohol resin, a polyvinyl butyral resin, a polyvinyl formal resin, a polyamide resin, a polyester resin and an epoxy resin. Particularly, a (meth)acrylic polymer, a polyurethane resin or a polyvinyl butyral resin is preferably used.

The term "(meth)acrylic polymer" as used herein means a copolymer containing as a polymerization component, (meth)aerylic acid or a (meth)acrylic acid derivative, for example, a (meth)acrylate (including, for example, an alkyl ester, aryl ester and allyl ester), (meth)acrylainide or a (meth)acrylamide derivative. The term "polyurethane resin" as used herein means a polymer formed by a condensation reaction of a compound having two or more isocyanate groups and a compound having two or more hydroxy groups.

The term "polyvinyl butyral resin" as used herein means a polymer synthesized by a reaction (acetalization reaction) of polyvinyl alcohol obtained by partial or full saponification of polyvinyl acetate with butylaldehyde under an acidic condition and includes a polymer wherein an acid group or the like is introduced by a method of reacting the remaining hydroxy group with a compound having the acid group or the like.

One preferable example of the (meth)acrylic polymer according to the invention is a copolymer containing a repeating unit having an acid group. Examples of the acid group include a carboxylic acid group, a sulfonic acid group, a phosphonic acid group, a phosphoric acid group and a sulfonamido group. Particularly, a carboxylic acid group is preferred. As the repeating unit having an acid group, a repeating unit derived from (meth)acrylic acid or a repeating unit represented by formula (I) shown below is preferably used.

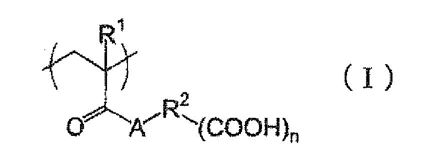

In formula (I), R¹ represents a hydrogen atom or a methyl group, R² represents a single bond or an (n+1) valent connecting group, A represents an oxygen atom or -NR³-, wherein R³ represents a hydrogen atom or a monovalent hydrocarbon group having from 1 to 10 carbon atoms, and n represents an integer from 1 to 5.

The connecting group represented by R² in formula (I) is constructed from a hydrogen atom, a carbon atom, an oxygen atom, a nitrogen atom, a sulfur atom and a halogen atom and preferably contains from 1 to 80 atoms. Specific examples of the connecting group include an alkylene group, a substituted alkylene group, an arylene group and a substituted arylene group. The connecting group may have a structure wherein a plurality of such divalent groups is connected to each other via any of an amido bond, an ether bond, a urethane bond, a urea bond and an ester bond. R² is preferably a single bond, an alkylene group, a substituted alkylene group or a structure where a plurality of an alkylene group and/or a substituted alkylene group is connected to each other via any of an amido bond, an ether bond, a urethane bond, a urea bond and an ester bond, particularly preferably a single bond, an alkylene group having from 1 to 5 carbon atoms, a substituted alkylene group having from 1 to 5 carbon atoms or a structure where a plurality of an alkylene group having from 1 to 5 carbon atoms and/or a substituted alkylene group having from 1 to 5 carbon atoms is connected to each other via any of an amido bond, an ether bond, a urethane bond, a urea bond and an ester bond, and most preferably a single bond, an alkylene group having from 1 to 3 carbon atoms, a substituted alkylene group having from 1 to 3 carbon atoms or a structure where a plurality of an alkylene group having from 1 to 3 carbon atoms and/or a substituted alkylene group having from 1 to 3 carbon atoms is connected to each other via any of an amido bond, an ether bond, a urethane bond, a urea bond and an ester bond.

Examples of the substituent include a monovalent non-metallic atomic group exclusive of a hydrogen atom, for example, a halogen atom (e.g., -F, -Br, -Cl or -I), a hydroxy group, a cyano group, an alkoxy group, an aryloxy group, a mercapto group, an alltylthio group, an arylthio group, an alkylcarbonyl group, an arylcarbonyl group, a carboxyl group and a conjugate base group thereof, an alkoxycarbonyl group, an aryloxycarbonyl group, a carbamoyl group, an aryl group, an alkenyl group and an alkynyl group.

R³ is preferably a hydrogen atom or a hydrocarbon group having from 1 to 5 carbon atoms, more preferably a hydrogen atom or a hydrocarbon group having from 1 to 3 carbon atoms, and particularly preferably a hydrogen atom or a methyl group. n is preferably from 1 to 3, more preferably 1 or 2, and particularly preferably 1.

A ratio (% by mole) of the copolymerization component having a carboxylic acid group in the total copolymerization components of the (meth)acrylic polymer is preferably from 1 to 70% in view of developing property. Considering good compatibility between the developing property and printing durability, it is more preferably from 1 to 50%, and particularly preferably from 1 to 30%.

It is preferred that the (meth)acrylic polymer for use in the invention further contain a crosslinkable group. The term "crosslinkable group" as used herein means a group capable of crosslinking the polymer in the process of a radical polymerization reaction which is caused in the photosensitive layer, when the lithographic printing plate precursor is exposed to light. The crosslinkable group is not particularly restricted as long as it has such a function and includes, for example, an ethylenically unsaturated bond group, an amino group and an epoxy group as a functional group capable of undergoing an addition polymerization reaction. Also, a functional group capable of forming a radical upon irradiation with light may be used and such a crosslinkable group includes, for example, a thiol group and a halogen atom. Among them, the ethylenically unsaturated bond group is preferred. The ethylenically unsaturated bond group preferably includes a styryl group, a (meth)acryloyl group and an allyl group.

In the polymer, for example, a free radical (a polymerization initiating radical or a propagating radical in the process of polymerization of the Polymerizable compound) is added to the crosslinkable functional group to cause addition polymerization between the polymers directly or through a polymerization chain of the polymerizable compound and as a result, crosslinking is formed between the polymer molecules to effect curing. Alternatively, an atom (for example, a hydrogen atom on the carbon atom adjacent to the functional crosslinkable group) in the polymer is withdrawn by a free radical to produce a polymer radical and the polymer radicals combine with each other to form crosslinking between the polymer molecules to effect curing.

The content of the crosslinkable group (content of radical-polymerizable unsaturated double bond determined by iodine titration) in the (meth)acrylic polymer is preferably from 0.01 to 10.0 mmol, more preferably from 0.05 to 9.0 mmol, particularly preferably from 0.1 to 8.0 mmol, per g of the polymer.

The (meth)acrylic polymer for use in the invention may contain a polymerization unit of alkyl (meth)acrylate or aralkyl (meth)acrylate, a polymerization unit of (meth)acrylamide or a derivative thereof, a polymerization unit of α-hydroxymethyl acrylate or a polymerization unit of a styrene derivative, in addition to the polymerization unit having an acid group and the polymerization unit having a crosslinkable group described above. The alkyl group in the alkyl (mem)acrylate is preferably an alkyl group having from 1 to 5 carbon atoms or an alkyl group having from 2 to 8 carbon atoms and the substituent described above, and more preferably a methyl group. The aralkyl (meth)acrylate includes, for example, benzyl (meth)acrylate. The (meth)acrylamide derivative includes, for example, N-isopropylacrylamide, N -phenylmethacrylamide, N -(4-methoxycarbonylphenyl)methacrylamide, N,N-diznethylacrylarnide and morpholinoacrylamide. The α-hydroxymethyl acrylate includes, for example, ethyl α-hydroxymethyl acrylate and cyclohexyl α-hydroxymethyl acrylate. The styrene derivative includes, for example, styrene and 4-tert-butylstyrene.

Preferable examples of the polyurethane resin for use in the invention include polyurethane resins described in Paragraph Nos. [0099] to [0210] of JP-A-2007-187836, Paragraph Nos. [0019] to [0100] of JP-A-2008-276155, Paragraph Nos. [0018] to [0107] of JP-A-2005-250438 and Paragraph Nos. [0021] to [0083] ofJP-A-2005-250158.

Preferable examples of the polyvinyl butyral resin for use in the invention include polyvinyl butyral resins described in Paragraph Nos. [0006] to [0013] of JP-A-2001-75279.

A part of the acid groups in the binder polymer may be neutralized with a basic compound. Examples of the basic compound include a compound containing a basic nitrogen, an alkali metal hydroxide and a quaternary ammonium salt of an alkali metal.

The binder polymer preferably has a weight average molecular weight of 5,000 or more, more preferably from 10,000 to 300,000, and a number average molecular weight of 1,000 or more, more preferably from 2,000 to 250,000. The polydispersity (weight average molecular weight/number average molecular weight) is preferably from 1.1 to 10.

The binder polymers may be used individually or in combination of two or more thereof. The content of the binder polymer is preferably from 5 to 75% by weight, more preferably from 10 to 70% by weight, still more preferably from 10 to 60% by weight, based on the total solid content of the photosensitive layer from the standpoint of good strength of the image area and good image-forming property.

The total content of the polymerizable compound and the binder polymer is preferably 90% by weight or less based on the total solid content of the photosensitive layer. When it exceeds 90% by weight, decrease in the sensitivity and deterioration in the developing property may be caused sometimes. The total content thereof is more preferably from 35 to 80% by weight.

The photosensitive layer preferably contains a chain transfer agent. The chain transfer agent is defined, for example, in Kobunshi Jiten (Polymer Dictionary), Third Edition, pages 683 to 684, edited by The Society of Polymer Science, Japan (2005). As the chain transfer agent, for example, compounds having SH, PH, SiH or GeH in their molecules are used. The compound donates a hydrogen to a low active radical species to generate a radical or is oxidized and then deprotonized to generate a radical. In the photosensitive layer according to the invention, a thiol compound (for example, a 2-mercaptobenzimidazole, a 2-mercaptobenzothiazole, a 2-mercaptobenzoxazole, a 3-mercaptotriazole or a 5-mercaptotetrazole) is preferably used.

The amount of the chain transfer agent added is preferably from 0.01 to 20 parts by weight, more preferably from 1 to 10 parts by weight, particularly preferably from 1 to 5 parts by weight, per 100 parts by weight of the total solid content of the photosensitive layer.

### (Other components for photosensitive layer)

Into the photosensitive layer, various additives can be further incorporated, if desired. Examples of the additive include a surfactant for progressing the developing property and improving the surface state of coated layer, a microcapsule for providing good compatibility between developing property and printing durability, a hydrophilic polymer for improving the developing property and dispersion stability of microcapsule, a coloring agent or print-out agent for visually distinguishing the image area from the non-image area, a polymerization inhibitor for preventing undesirable thermal polymerization of the radical polymerizable compound during the production and preservation of the photosensitive layer, a hydrophobic low molecular weight compound, for example, a higher fatty acid derivative for avoiding polymerization inhibition due to oxygen, a fine inorganic particle or fine organic particle for increasing strength of the cured layer in the image area, a hydrophilic low molecular weight compound for improving the developing property, a co-sensitizer for increasing sensitivity, and a plasticizer for improving plasticity. As the additives, known compounds, for example, compounds described in Paragraph Nos. [0161] to [0215] of JP-A-2007-206217, Paragraph No. [0067] of JP-T-2005-509192 and Paragraph Nos. [0023] to [0026] and [0059] to [0066] of JP-A-2004-310000 are used. With respect to the surfactant, surfactants which may be added to the developer described hereinafter may be used.

### <Formation of photosensitive layer>

The photosensitive layer is formed by dispersing or dissolving each of the necessary constituting components described above in a solvent to prepare a coating solution and coating the solution. The solvent used include, for example, methyl ethyl ketone, ethylene glycol monomethyl ether, 1-methoxy-2-propanol, 2-methoxyethyl acetate, 1-methoxy-2-propyl acetate and y-butyrolactone, but the invention should not be construed as being limited thereto. The solvents may be used individually or as a mixture. The solid content concentration of the coating solution is preferably from 1 to 50% by weight.

The coating amount (solid content) of the photosensitive layer after the coating and drying is preferably from 0.3 to 3.0 g/m². Various methods can be used for the coating. Examples of the method include bar coater coating, spin coating, spray coating, curtain coating, dip coating, air knife coating, blade coating and roll coating.

### [Protective layer]

In the lithographic printing plate precursor according to the invention, a protective layer (oxygen-blocking layer) is provided on the photosensitive layer in order to prevent diffusion and penetration of oxygen which inhibits the polymerization reaction at the time of exposure. As a material for the protective layer, any water-soluble polymer and water-insoluble polymer can be appropriately selected to use. The polymers may be used in combination of two or more thereof, if desired. Specifically, for example, polyvinyl alcohol, a modified polyvinyl alcohol, polyvinyl pyrrolidone, a water-soluble cellulose derivative and poly(meth)acrylonitrile are exemplified. Among them, a water-soluble polymer relatively excellent in crystallizability is preferably used. Specifically, when polyvinyl alcohol is used as a main component, the most preferred results can be obtained in the fundamental characteristics, for example, oxygen-blocking property and removability by development.

Polyvinyl alcohol for use in the protective layer may be partially substituted with ester, ether or acetal as long as it contains unsubstituted vinyl alcohol units for achieving the necessary oxygen-blocking property and water solubility. Also, polyvinyl alcohol may partly have other copolymer component. Polyvinyl alcohol is obtained by hydrolysis of polyvinyl acetate. As specific examples of the polyvinyl alcohol, those having a hydrolysis degree of 69.0 to 100% by mole and a polymerization repeating unit number of 300 to 2,400 are exemplified. Specific examples thereof include PVA-102, PVA-103, PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-235, PVA-217EE, PVA-217E, PVA-220E, P"VA-224E, PVA-403, PVA-405, PVA-420, PVA-424H, PVA-505, PVA-617, PVA-613, PVA-706 and L-8 (produced by Kuraray Co., Ltd.). The polyvinyl alcohols can be used individually or as a mixture. The content of polyvinyl alcohol in the protective layer is preferably from 20 to 95% by weight, and more preferably from 30 to 90% by weight.

Also, known modified polyvinyl alcohol can be preferably used. Particularly, an acid-modified polyvinyl alcohol having a carboxylic acid group or a sulfonic acid group is preferably used. Specifically, modified polyvinyl alcohols described in JP-A-2005-250216 and JP-A-2006-25913 are preferably exemplified.

When the polyvinyl alcohol is used as a mixture with other material, as the other material mixed, a modified polyvinyl alcohol, polyvinyl pyrrolidone or a modified product thereof is preferred from the viewpoint of the oxygen-blocking property and removability by development. The content thereof in the protective layer is ordinarily from 3.5 to 80% by weight, preferably from 10 to 60% by weight, and more preferably from 15 to 30% by weight.

As other component of the protective layer, glycerin, dipropylene glycol or the like can be added in an amount corresponding to several % by weight of the polymer to provide flexibility. Further, an anionic surfactant, for example, sodium alkylsulfate or sodium alkylsulfonate, an amphoteric surfactant, for example, alkylaminocarboxylate and alkylaminodicarboxylate, or a nonionic surfactant, for example, polyoxyethylene alkyl phenyl ether can be added in an amount of several % by weight of the polymer.

Further, it is also preferred to incorporate an inorganic stratiform compound into the protective layer for the purpose of improving the oxygen-blocking property and property for protecting the surface of photosensitive layer. Of the inorganic stratiform compounds, fluorine based swellable synthetic mica, which is a synthetic inorganic stratiform compound, is particularly useful. Specifically, inorganic stratiform compounds described in JP-A-2005-119273 are preferably exemplified.

The coating amount of the protective layer is preferably from 0.05 to 10 g/m² in terms of the coating amount after drying. When the protective layer contains the inorganic stratiform compound, it is more preferably from 0.1 to 5 g/m², and when the protective layer does not contain the inorganic stratiform compound, it is more preferably from 0.5 to 5 g/m².

### <Support>

A support for use in the lithographic printing plate precursor according to the invention is not particularly restricted as long as it is a dimensionally stable plate-like hydrophilic support. Particularly, an aluminum plate is preferred. In advance of the use of an aluminum plate, the aluminum plate is preferably subjected to a surface treatment, for example, roughening treatment or anodizing treatment. The roughening treatment of the surface of the aluminum plate is conducted by various methods and includes, for example, mechanical roughening treatment, electrochemical roughening treatment (roughening treatment of electrochemically dissolving the surface) and Chemical roughening treatment (roughening treatment of chemically dissolving the surface selectively). With respect to these treatments, methods described in Paragraph Nos. [0241] to [0245] of JP-2007-206217 are preferably used.

The center line average roughness of the support is preferably from 0.10 to 1.2 µm. In the range described above, good adhesion property to the photosensitive layer and good printing durability and good resistance to stain are achieved.

The color density of the support is preferably from 0.15 to 0.65 in terms of the reflection density value. In the range described above, good image-forming property by preventing halation at the image exposure and good aptitude for plate inspection after development are achieved.

The thickness of the support is preferably from 0.1 to 0.6 mm, more preferably from 0.15 to 0.4 mm, and still more preferably from 0.2 to 0.3 mm.

### [Hydrophilizing treatment of support and undercoat layer]

As for the lithographic printing plate precursor, in order to increase hydrophilicity of the non-image area and to prevent printing stain, it is preferred to conduct a hydrophilizing treatment of the surface of support or to provide an undercoat layer between the support and the photosensitive layer.

The hydrophilizing treatment of the surface of support includes an alkali metal silicate treatment method wherein the support is subjected to an immersion treatment or an electrolytic treatment in an aqueous solution, for example, of sodium silicate, a method of treating with potassium fluorozirconate and a method of treating with polyvinylphosphonic acid. An immersion treatment in an aqueous polyvinylphosphonic acid solution is preferably used.

As the undercoat layer, an undercoat layer containing a compound having an acid group, for example, a phosphonic acid group, a phosphoric acid group or a sulfonic acid group is preferably used. It is preferred for the compound to further have a polymerizable group in order to increase the adhesion property to the photosensitive layer. As the polymerizable group, an ethylenically unsaturated bond group is preferred. Also, a compound further having a hydrophilicity-imparting group, for example, an ethyleneoxy group is exemplified as a preferable compound.

These compounds may be low molecular weight compounds or polymer compounds. These compounds may be used in combination of two or more thereof, if desired.

For example, a silane coupling agent having an addition-polymerizable ethylenically unsaturated bond group described in JP-A-10-282679 and a phosphorus-containing compound having an ethylenically unsaturated bond group described in JP-A-2-304441 are preferably exemplified. It is also preferred to use a low molecular weight compound or polymer compound having a crosslinkable group (preferably an ethylenically unsaturated bond group), a functional group capable of interacting with the surface of support and a hydrophilic group described in JP-A-2005-238816, JP-A-2005-125749, JP-A-2006-239867 and JP-A-2006-215263.

The undercoat layer is coated according a known method. The coating amount (solid content) of the undercoat layer is preferably from 0.1 to 100 mg/m², and more preferably from 1 to 30 mg/m².

### [Backcoat layer]

A backcoat layer can be provided on the back surface (surface opposite to the surface provided with the photosensitive layer) of the support, if desired. The backcoat layer preferably includes, for example, a layer comprising an organic polymer compound described in JP-A-5-45885 and a coating layer comprising a metal oxide obtained by hydrolysis and polycondensation of an organic metal compound or inorganic metal compound described in JP-A-6-35174. Among them, use of an alkoxy compound of silicon, for example, Si(OCH₃)₄, Si(OC₂H₅)₄, Si(OC₃H₇)₄ or Si(OC₄H₉)₄ is preferred since the starting material is inexpensive and easily available.

### [Method of preparing lithographic printing plate]

The lithographic printing plate precursor according to the invention is exposed imagewise and then subjected to development processing to prepare a lithographic printing plate.

### <Image exposure step>

The lithographic printing plate precursor is, for example, exposed with laser through a transparent original having a line image, a halftone dot image or the like, or imagewise exposed by scanning of laser beam based on digital data.

The wavelength of the exposure light source is preferably from 300 to 450 nm or from 750 to 1,400 nm. In case of exposing with light of 300 to 450 nm the lithographic printing plate precursor having a photosensitive layer containing a sensitizing dye having an absorption maximum in such a wavelength range is used. In case of exposing with light of 750 to 1,400 nm, the lithographic printing plate precursor containing an infrared absorbing agent which is a sensitizing dye having an absorption maximum in such a wavelength range is used. As the light source having a wavelength from 300 to 450 nm, a semiconductor laser is preferably used. As the light source having a wavelength from 750 to 1,400 nm, a solid laser or semiconductor laser emitting an infrared ray is preferably used. The exposure mechanism may be any of an internal drum system, an external drum system and a flat bed system.

### <Development processing step>

The development processing in the method of preparing a lithographic printing plate according to the invention is characterized by conducting using a developer having pH of 2 to 11 and containing a vinyl copolymer (water-soluble polymer compound of specific structure) containing a monomer unit having at least one functional group capable of interacting with a surface of the support and a monomer unit having at least one hydrophilic group.

Specifically, according to the method of preparing a lithographic printing plate of the invention, the protective layer and the unexposed area of the photosensitive layer can be removed together by the development processing described above. After the development processing, the printing plate obtained can be immediately mounted on a printing machine to print.

According to the hitherto known development processing using an alkali developer, it is necessary that a protective layer is removed in a pre-water washing step, the alkali development is conducted, the alkali is removed by washing with water in a post-water washing step, gum solution treatment is conducted and drying is conducted in a drying step. On the contrary, in the development processing according to the invention, since the protective layer is removed at the same time, the pre-water washing step is not necessary. Further, the development and gum solution treatment step can be conducted at the same time by incorporating a surfactant or a water-soluble polymer compound including the water-soluble polymer compound of specific structure into the developer. Thus, the post-water washing step is not particularly necessary, and after conducting the development and gum solution treatment with one solution, the drying step can be performed. After the development processing, the excess developer is preferably removed using a squeeze roller, followed by drying.

One preferred embodiment of the method of preparing a lithographic printing plate according to the invention is characterized by not containing a water washing step. In the above embodiment, the term "not containing a water washing step" means that any water washing step is not contained between the image exposure step and the completion of the preparation of a lithographic printing plate through the development processing step. Specifically, according to the embodiment, a lithographic printing plate is prepared without undergoing a water washing step not only between the image exposure step and the development processing step but also after the development processing step. The lithographic printing plate prepared can be used for printing as it is.

The development processing is performed at temperature from 0 to 60°C, preferably from about 15 to about 40°C in a conventional manner, for example, by a method wherein the imagewise exposed lithographic printing plate precursor is immersed in the developer and rubbed with a brush or a method wherein the developer is sprayed to the imagewise exposed lithographic printing plate precursor and the lithographic printing plate precursor is rubbed with a brush.

The development processing in the invention is preferably performed by an automatic development processor equipped with a supplying means for the developer and a rubbing member. An automatic development processor using a rotating brush roller as the rubbing member is particularly preferred. The number of the rotating brush rollers is preferably two or more. Further, the automatic development processor is preferably provided with a means for removing the excess developer, for example, a squeeze roller, or a drying means, for example, a hot air apparatus, subsequently to the development processing means. Further, the automatic development processor may be provided with a pre-heating means for conducting pre-heating treatment of the lithographic printing plate precursor after image exposure prior to the development processing means. The development processing by such an automatic development processor has an advantage in that it is free from the measures against development scum resulting from the protective layer and/or photosensitive layer encountered in the on-press development.

One example of the automatic development processor for use in the method of preparing a lithographic printing plate according to the invention is briefly described with reference to Fig. 1.

An automatic development processor 100 shown in Fig.1 comprises a chamber the outer shape of which is formed by a machine casing 202 and has a pre-heating unit 200, a developing unit 300 and a drying unit 400 continuously formed along a transporting direction (arrow A) of a transporting pass 11 for a lithographic printing plate precursor.

The pre-heating unit 200 comprises a heating chamber 208 having a transporting inlet 212 and a transporting outlet 218 and a skewer roller 210, a heater 214 and a circulation fan 216 6 are arranged in the inside thereof.

The developing unit 300 is separated from the pre-heating unit 200 by an outer panel 310 and a slit type insertion slot 312 is formed in the outer panel 310.

In the inside of the developing unit 300, a processing tank 306 having a developing tank 308 filled with a developer and an insertion roller pair 304 for guiding the lithographic printing plate precursor into the inside of the processing tank 306 are disposed. A shielding cover 324 is located above the developing tank 308.

In the inside of the developing tank 308, a guide roller 344 and a guide member 342, a submerged roller pair 316, a brush roller pair 322, a brush roller pair 326 and a carrying-out roller pair 318 are provided in order from the upstream side of the transporting direction of lithographic printing plate precursor. The lithographic printing plate precursor transported into the developing tank 308 is immersed in the developer and the non-image area is removed by passing between the rotating brush roller pairs 322 and 326.

A spray pipe 330 is provided under the brush roller pairs 322 and 326. The spray pipe 330 is connected to a pump (not shown) and the developer in the developing tank 308 sucked by the pump is ejected from the spray pipe 330 in the developing tank 308.

On a sidewall of the developing tank 308, an overflow aperture 51 is provided to form a top edge of a first circulation pipeline C1. The excess developer flows in the overflow aperture 51, passes through the first circulation pipeline C1 and is discharged in an external tank 50 provided outside the developing unit 300.

To the external tank 50 is connected a second circulation pipeline C2 and a filter unit 54 and a developer supply pump 55 are located in the second circulation pipeline C2. The developer is supplied from external tank 50 to the developing tank 308 by the developer supply pump 55. In the external tank 50, an upper limit liquid level meter 52 and a lower limit liquid level meter 53 are provided.

The developing tank 308 is also connected to a water tank for replenishment 71 through a third circulation pipeline C3. A water-replenishing pump 72 is located in the third circulation pipeline C3 and water pooled in the water tank for replenishment 71 is supplied to the developing bath 308 by the water-replenishing pump 72.

A liquid temperature sensor 336 is provided on the upstream side of the submerged roller pair 316. A liquid level meter 338 is provided on the upstream side of the carrying-out roller pair 318.

In a partition board 332 placed between the developing unit 300 and the drying unit 400, a slit type pass-through slot 334 is formed. Also, a shutter (not shown) is provided along a passage between the developing unit 300 and the drying unit 400 and the passage is closed by the shutter when the lithographic printing plate precursor does not pass through the passage.

In the drying unit 400, a support roller 402, ducts 410 and 412, a transport roller pair 406, ducts 410 and 412 and a transport roller pair 408 are disposed in this order. A slit hole 414 is provided at the top of each of the ducts 410 and 412. In the drying unit 400, a drying means (not shown), for example, a hot air supplying means or a heat generating means, is also provided. The drying unit 400 has a discharge slot 404 and the resulting lithographic printing plate dried by the drying means is discharged through the discharge slot 404.

The developer for use in the method of preparing a lithographic printing plate according to the invention is an aqueous solution having pH of 2 to 11 and containing the water-soluble polymer compound of specific structure. The developer preferably contains water as the main component (containing 60% by weight or more of water). Further, an aqueous solution containing a surfactant (for example, an anionic, nonionic, cationic or amphoteric surfactant) is preferred. The pH of the developer is preferably from 5 to 10.7, more preferably from 6 to 10.5, and particularly preferably from 6.8 to 9.9.

The water-soluble polymer compound of specific structure for use in the developer according to the invention is a vinyl copolymer containing a monomer having a functional group capable of interacting with a surface of the support and a monomer having a hydrophilic group as the polymerization components.

The functional group capable of interacting with a surface of the support includes a group capable of forming a covalent bond, an ionic bond, a hydrogen bond or the like or a group capable of undergoing an interaction, for example, a polar interaction, with metal, a metal oxide, a hydroxy group or the like present on the support. Among them, a functional group (an adsorbing group) adsorbing to a surface of the support is preferred.

Whether the adsorptivity to the surface of support is present or not can be judged, for example, by the following method.

Specifically, a test compound is dissolved in a solvent in which the test compound is easily soluble to prepare a coating solution, and the coating solution is coated and dried on a support so as to have the coating amount after drying of 30 mg/m². After thoroughly washing the support coated with the test compound using the solvent in which the test compound is easily soluble, the residual amount of the test compound that has not been removed by the washing is measured to calculate the adsorption amount of the test compound to the support. For measurement of the residual amount, the amount of the residual test compound may be directly determined, or it may be calculated from the amount of the test compound dissolved in the washing solution. The determination for the compound can be performed, for example, by fluorescent X-ray measurement, reflection spectral absorbance measurement or liquid chromatography measurement. The compound having the adsorptivity to support means a compound that remains by 0.1 mg/m² or more even after conducting the washing treatment described above.

The adsorbing group in the water-soluble polymer compound of specific structure to surface of support is a functional group capable of forming a chemical bond (for example, an ionic bond, a hydrogen bond, a coordinate bond or a bond with intermolecular force) with a substance (for example, metal or a metal oxide) or a functional group (for example, a hydroxy group) present on the surface of support. The adsorbing group is preferably an acid group or a cationic group.

The acid group preferably has an acid dissociation constant (pKa) of 7 or less. Examples of the acid group include a phenolic hydroxy group, a carboxyl group, -SO₃H, -OSO₃H, -PO₃H₂, -OPO₃H₂, -BO₃H₂, -CONHSO₂-, -SO₂NHSO₂- and -COCH₂COCH₃. Among them, -OPO₃H₂ or -PO₃H₂ is particularly preferred. The acid group may be the form of a metal salt or an onium salt.

The cationic group is preferably an onium group. Examples of the onium group include an ammonium group (including a cyclic ammonium group, for example, a pyridinium group), a phosphonium group, an arsonium group, a stibonium group, an oxonium group, a sulfonium group, a selenonium group, a stannonium group and iodonium group. Among them, an ammonium group, a phosphonium group or a sulfonium group is preferred, an ammonium group or a phosphonium group is more preferred, and an ammonium group is particularly preferred.

A phosphoric ester group (including a salt thereof) or a β-diketone group (for example, an acetylacetone group) is also preferred as the adsorbing group to surface of support.

Preferable examples of the adsorbing group to surface of support are set forth below.

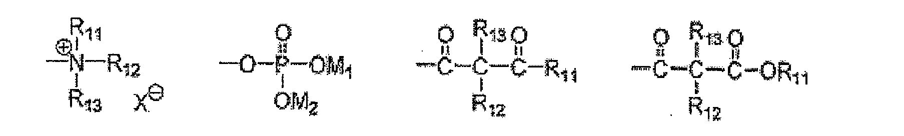

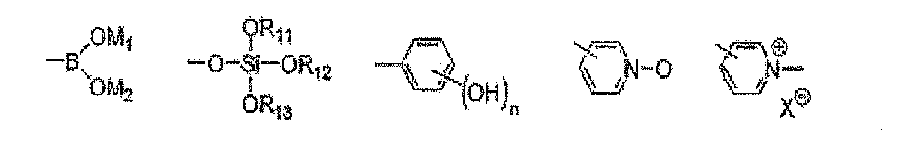

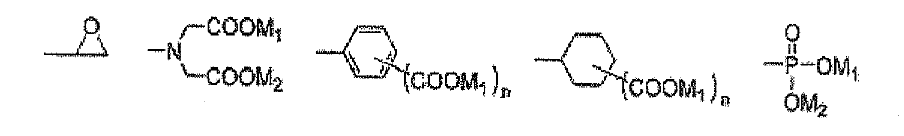

In the above-formulae, R₁ to R₁₃ each independently represents a hydrogen atom, an alkyl group, an aryl group, an alkynyl group or an alkenyl group. M₁ and M₂ each independently represents a hydrogen atom, a metal atom or an ammonium group. X represents a counter anion. n represents an integer from 1 to 5.

As the adsorbing group, an onium group, a phosphoric ester group or a salt thereof, a phosphonic acid group or a salt thereof, a boric acid group or a salt thereof or a β-diketone group is particularly preferred. The phosphoric ester group or phosphonic acid group is most preferred.

A repeating unit corresponding to the monomer having the functional group capable of interacting with the surface of support is represented, for example, by formula (A1) shown below.

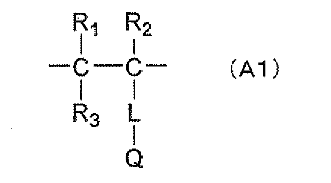

In formula (A1), R₁ to R₃ each independently represents a hydrogen atom, an alkyl group having from 1 to 6 carbon atoms or a halogen atom. L represents a single bond or a divalent connecting group selected from the group consisting of-CO-, -O-, -NH-, a divalent aliphatic group, a divalent aromatic group and a combination thereof. Q represents a functional group capable of interacting with the surface of support.

Specific examples of the functional group capable of interacting with the surface of support are same as those described above.

Specific examples of the divalent connecting group composed of the combination of groups represented by L are set forth below. In each of the specific examples shown below, the left side connects to the main chain.
L1: -CO-NH-divalent aliphatic group-O-CO-
L2: -CO-divalent aliphatic group-O-CO-
L3: -CO-O-divalent aliphatic group-O-CO-
L4: -divalent aliphatic group-O-CO-
L5: -CO-NH-divalent aromatic group-O-CO-
L6: -CO-divalent aromatic group-O-CO-
L7: -divalent aromatic group-O-CO-
L8: -CO-O-divalent aliphatic group-CO-O-divalent aliphatic group-O-CO-
L9: -CO-O-divalent aliphatic group-O-CO-divalent aliphatic group-O-CO-
L10: -CO-O-divalent aromatic group-CO-O-divalent aliphatic group-O-CO-
L11: -CO-O-divalent aromatic group-O-CO-divalent aliphatic group-O-CO-
L12: -CO-O-divalent aliphatic group-CO-O-divalent aromatic group-O-CO-
L13: -CO-O-divalent aliphatic group-O-CO-divalent aromatic group-O-CO-
L14: -CO-O-divalent aromatic group-CO-O-divalent aromatic group-O-CO-
L15: -CO-O-divalent aromatic group-O-CO-divalent aromatic group-O-CO-
L16: -CO-O-divalent aromatic group-O-CO-NH-divalent aliphatic group-O-CO-
L17: -CO-O-divalent aliphatic group-O-CO-NH-divalent aliphatic group-O-CO-
L18:-CO-NH-
L19:-CQ-O-

particularly preferable examples of the monomer having a functional group capable of interacting with a surface of the support include compounds represented by formula (VII) or (VIII) shown below.

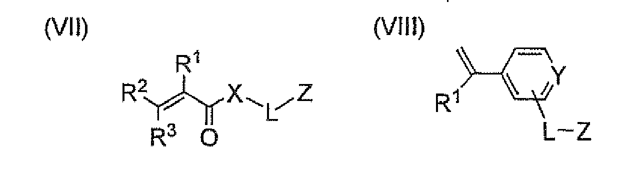

In formula (VM) or (VIII), R¹, R² and R³ each independently represents a hydrogen atom, halogen atom or an alkyl group having from 1 to 6 carbon atoms. R¹, R² and R³ each independently represents preferably a hydrogen atom or an alkyl group having from 1 to 6 carbon atoms, more preferably a hydrogen atom or an alkyl group having from 1 to 3 carbon atoms, and particularly preferably a hydrogen atom or a methyl group. R² and R³ are particularly preferably hydrogen atoms, respectively.

In formula (VII), X represents an oxygen atom (-O-) or imino group (-NH-). X is preferably an oxygen atom.

In the formula (VII) or (VIII), L represents a divalent connecting group. L is preferably a divalent aliphatic group (for example, an alkylene group, a substituted alkylene group, an alkenylene group, a substituted alkenylene group, an alkinylene group or a substituted alkinylene group), a divalent aromatic group (for example, an arylene group or a substituted arylene group), a divalent heterocyclic group or a combination of each of the groups described above with an oxygen atom (-O-), a sulfur atom (-S-), an imino group (-NH-), a substituted imino group (-NR-, wherein R represents an aliphatic group, an aromatic group or a heterocyclic group) or a carbonyl group (-CO-).

The aliphatic group may form a cyclic structure or a branched structure. A number of carbon atoms of the aliphatic group is preferably from 1 to 20, more preferably from 1 to 15, and particularly preferably from 1 to 10. Of the aliphatic groups a saturated aliphatic group is more preferable than an unsaturated aliphatic group. The aliphatic group may have a substituent. Examples of the substituent include a halogen atom, a hydroxy group, an aromatic group and a heterocyclic group.

A number of carbon atoms of the aromatic group is preferably from 6 to 20, more preferably from 6 to 15, and particularly preferably from 6 to 10. The aromatic group may have a substituent. Examples of the substituent include a halogen atom, a hydroxy group, an aliphatic group, an aromatic group and a heterocyclic group.

The heterocyclic group preferably has a 5-membered or 6-membered ring as the hetero ring. Other heterocyclic ring, an aliphatic ring or an aromatic ring may be condensed to the heterocyclic ring. The heterocyclic group may have a substituent. Examples of the substituent include a halogen atom, a hydroxy group, an oxo group (=O), a thioxo group (=S), an imino group (=NH), a substituted imino group (=N-R, wherein R represents an aliphatic group, an aromatic group or a heterocyclic group), an aliphatic group, an aromatic group and a heterocyclic group.

L is preferably a divalent connecting group containing a plurality of polyoxyalkylene structures. The polyoxyalkylene structure is more preferably a polyoxyethylene structure. Specifically, L preferably contains -(OCH₂CH₂)ₙ- (wherein n is an integer of 2 or more).

In formula (VII) or (VIII), Z represents an adsorbing group to surface of support. The adsorbing group to surface of support is same as that described above.

In formula (VIII), Y represents a carbon atom or a nitrogen atom. In the case where Y is a nitrogen atom and L is connected to Y to form a quaternary pyridinium group, Z is not mandatory, because the quaternary pyridinium group itself exhibits the adsorptivity.

Representative examples of the monomer represented by formula (VII) or (VIII) are set forth below.

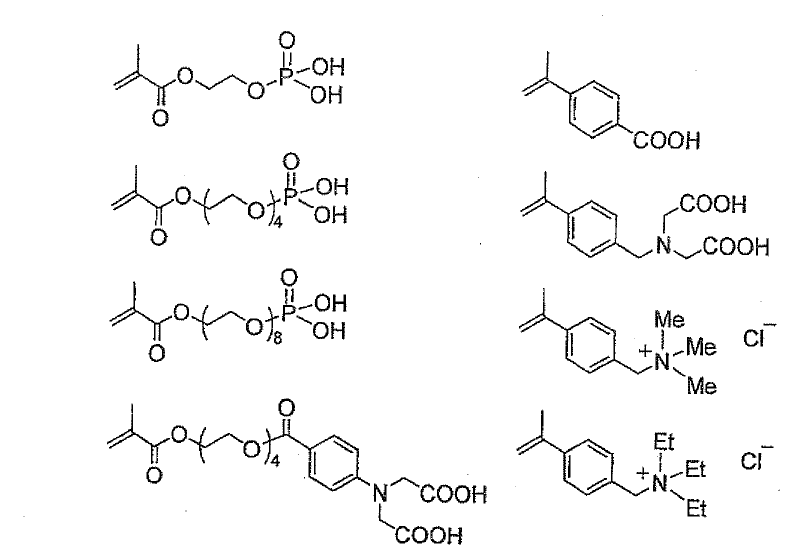

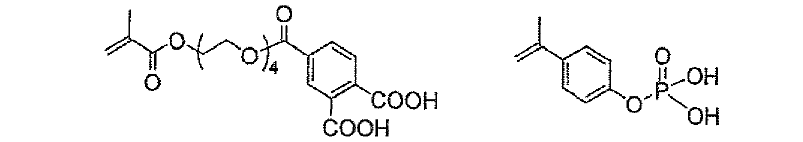

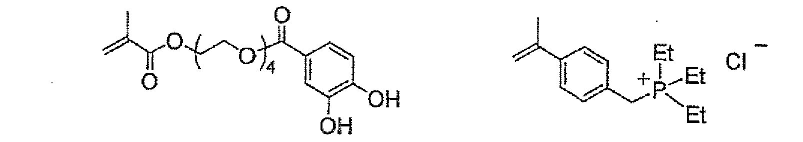

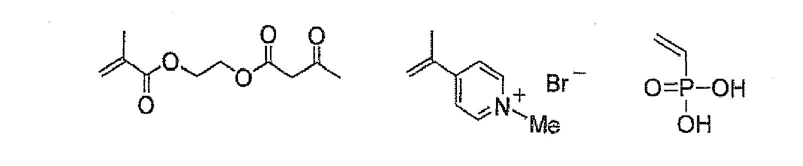

The water-soluble polymer compound of specific structure may contain only one kind or two or more kinds of the monomer unit having the functional group capable of interacting with a surface of the support.

The content of the monomer unit having the functional group capable of interacting with a surface of the support in the water-soluble polymer compound of specific structure is preferably from 2 to 80% by mole, more preferably from 2 to 70% by mole, still more preferably from 5 to 50% by mole, particularly preferably from 10 to 50% by mole, based on the total monomer unit contained in the water-soluble polymer compound of specific structure.

The hydrophilic group in the water-soluble polymer compound of specific structure for use in the developer according to the invention preferably includes, for example, a hydroxy group, a carboxyl group, a carboxylate group, a hydroxyethyl group, a hydroxypropyl group, a polyoxyalkylene group, for example, a polyoxyethylene group or a polyoxypropylene group, an amino group, an aminoethyl group, an aminopropyl group, an ammonium group, an amido group, a carboxymethyl group, a sulfonic acid group or a salt thereof and a group having a betain structure.

In the water-soluble polymer compound of specific structure, the functional group capable of interacting with a surface of the support interacts with a surface of the support and contributes in that the polymer compound adsorbs on the surface of support corresponding to the non-image area at the development and the hydrophilic group imparts high hydrophilicity to the polymer compound adsorbed to contribute to stain prevention in the non-image area.

The more preferable hydrophilic group includes a sulfonic acid group (-SO₃H) or a salt thereof (-SO₃M, wherein M represents a counter cation other than a proton (H)), an amido group (-CONR-, wherein R represents a hydrogen atom or an organic group), a polyalkyleneoxy group and a group having a betain structure.

The betain structure is a structure having both a cation structure and an anion structure and an electric charge is neutralized therein. The cation structure in the betain structure is not particularly restricted and is preferably a quaternary nitrogen cation. The anion structure in the betain structure is not particularly restricted and is preferably -COO⁻, -SO₃⁻, -PO₃²⁻ or -PO₃H⁻, and more preferably ―COO⁻ or -SO₃⁻.

The still more preferable hydrophilic group is a sulfonic acid group or a salt thereof or a group having a betain structure.

A repeating unit corresponding to the monomer having a hydrophilic group is represented, for example, by formula (A2) shown below.

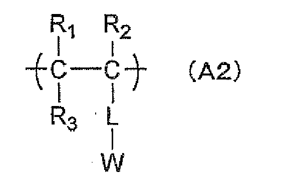

In formula (A2), R₁ to R₃ and L have the same meanings as defined in formula (A1), respectively. W represents a group shown below.

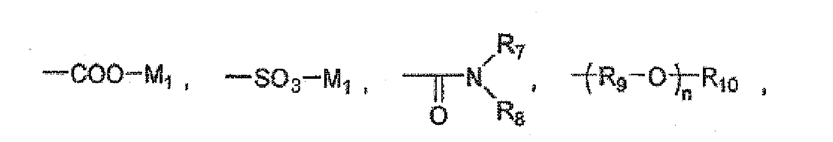

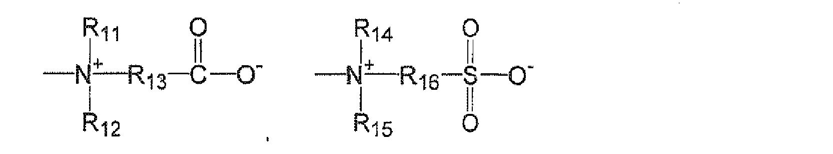

In the formulae, M₁ has the same meaning as M₁ defined with respect to formula (A1) above.

R₇, R₈, R₁₁, R₁₂, R₁₄ and R₁₅ each independently represents a hydrogen atom or a straight chin or branched alkyl group having from 1 to 6 carbon atoms. R₉ represents a straight chin or branched alkylene group having from 1 to 6 carbon atoms, and preferably an ethylene group. R₁₀ represents a hydrogen atom or an alkyl group having from 1 to 12 carbon atoms n represents an integer from 1 to 100, and preferably an integer from 1 to 30. R₁₃ and R₁₆ each independently represents a divalent organic group, for example, a divalent connecting group selected from the group consisting of a divalent aliphatic group, a divalent aromatic group and a combination of these groups.

Specific examples of the repeating unit corresponding to the monomer having a hydrophilic group are set forth below.

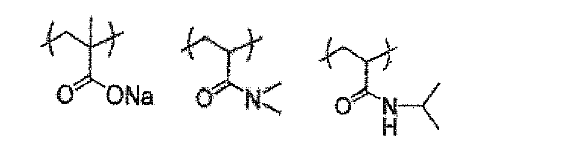

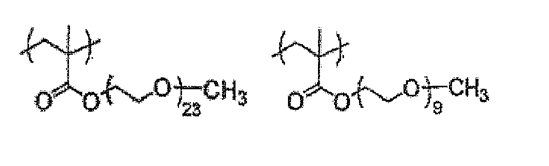

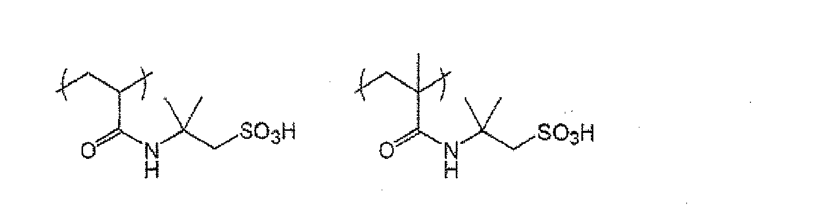

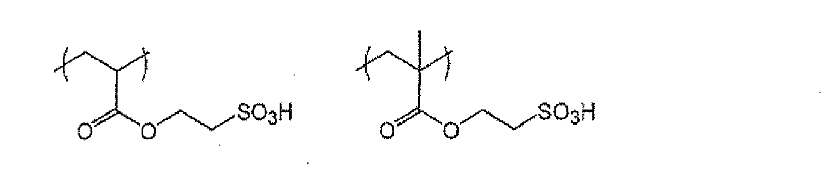

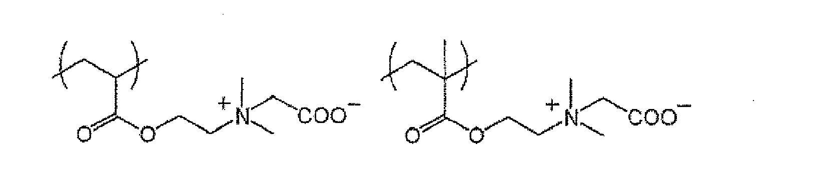

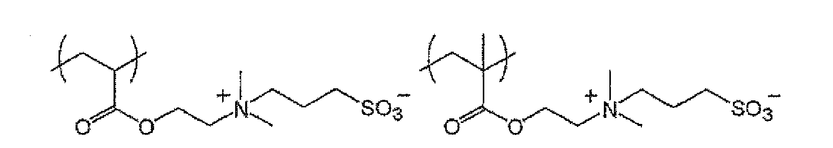

The repeating unit having at least one hydrophilic group represented by formula (A2) preferably has log P from -3 to 3, and more preferably from -1 to 2. In the range described above, the stain preventing property in the non-image area is more preferably achieved.

The term "log P" as used herein means a logarithm of a value of octanol/water partition coefficient (P) of a compound calculated using software PC Models developed by Medicinal Chemistry Project, Pomona College, Claremont, California and available from Daylight Chemical Information Systems, Inc.

The water-soluble polymer compound of specific structure may contain only one kind or two or more kinds of the monomer unit having a hydrophilic group.

The content of the monomer unit having a hydrophilic group in the water-soluble polymer compound of specific structure is preferably from 30 to 98% by mole, more preferably from 40 to 90% by mole, and still more preferably from 50 to 90% by mole, based on the total monomer unit contained in the water-soluble polymer compound of specific structure.

In the water-soluble polymer compound of specific structure, the functional group capable of interacting with a surface of the support contained in the monomer unit having a functional group capable of interacting with a surface of the support is a group different from the hydrophilic group contained in the monomer unit having a hydrophilic group.

Further, the water-soluble polymer compound of specific structure for use in the developer according to the invention may contain a monomer unit other than the monomer unit having a functional group capable of interacting with a surface of the support and a monomer unit having a hydrophilic group, so far as the performance of the invention is not damaged.

The other monomer unit is not particularly restricted and may be any monomer unit formed by copolymerization of a known monomer. Examples of the other monomer include a (meth)acrylate and a (meth)acrylamide.

The content of the other monomer unit in the water-soluble polymer compound of specific structure is preferably 40% by mole or less, more preferably 30% by mole or less, and still more preferably 20% by mole or less, based on the total monomer unit contained in the water-soluble polymer compound of specific structure.

The water-soluble polymer compound of specific structure for use in the developer according to the invention is a vinyl copolymer. The term "vinyl copolymer" as used herein means a copolymer obtained by copolymerization of two or more kinds of monomer having an ethylenically unsaturated bond, for example, an acrylate, a methacrylate, a styrene, an aromatic vinyl compound, an aliphatic vinyl compound, an allyl compound, acrylic acid or methacrylic acid.

The water-soluble polymer compound of specific structure may be any of a random copolymer, a block copolymer, a graft copolymer and the like, and it is preferably a random copolymer.

The monomer unit having a functional group capable of interacting with a surface of the support, monomer unit having a hydrophilic group and other monomer unit are monomer units obtained from monomers having an ethylenically unsaturated bond.

The weight average molecular weight of the water-soluble polymer compound of specific structure is preferably 5,000 or more, more preferably 10,000 or more, and preferably 1,000,000 or less, more preferably 500,000 or less.

The number average molecular weight of the water-soluble polymer compound of specific structure is preferably 1,000 or more, more preferably 2,000 or more, and preferably 500,000 or less, more preferably 300,000 or less.

The polydispersity (weight average molecular weight/number average molecular weight) of the water-soluble polymer compound of specific structure is preferably from 1.1 to 10.

The developer according to the invention may contain only one kind or two or more kinds of the water-soluble polymer compound of specific structure.

The content of the water-soluble polymer compound of specific structure in the developer according to the invention is preferably from 0.1 to 20% by weight, more preferably from 0.5 to 10% by weight, still more preferably from 2 to 10% by weight. In the range described above, good stain preventing effect in the non-image area is obtained.

The anionic surfactant for use in the developer is not particularly limited and includes, for example, fatty acid salts, abietic acid salts, hydroxyalkanesulfonic acid salts, alkanesulfonic acid salts, dialkylsulfosuccinic acid salts, straight-chain alkylbenzenesulfonic acid salts, branched alkylbenzenesulfonic acid salts, alkylnaphthalenesulfonic acid salts, alkyldiphenylether (di)sulfonic acid salts, alkylphenoxy polyoxyethylene alkylsulfonic acid salts, polyoxyethylene alkylsulfophenyl ether salts, N-alkyl-N-oleyltaurine sodium salt, N-alkylsulfosuccinic acid monoamide disodium salts, petroleum sulfonic acid salts, sulfated castor oil, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styryl phenyl ether sulfate ester salts, alkyl phosphate ester salts, polyoxyethylene alkyl ether phosphate ester salts, polyoxyethylene alkyl phenyl ether phosphate ester salts, partially saponified products of styrene-maleic anhydride copolymer, partially saponified products of olefin-maleic anhydride copolymer and naphthalene sulfonate formalin condensates. Of the compounds, alkylbenzenesulfonic acid salts, alkylnaphthalenesulfonic acid salts and alkyldiphenylether (di)sulfonic acid salts are particularly preferably used.

The cationic surfactant for use in the developer is not particularly limited and hitherto known cationic surfactants may be used. For example, alkylamine salts, quaternary ammonium salts, alkylimidazolinium salts, polyoxyethylene alkyl amine salts and polyethylene polyamine derivatives are exemplified.

The nonionic surfactant for use in the developer is not particularly limited and includes, for example, polyethylene glycol type higher alcohol ethylene oxide adducts, alkylphenol ethylene oxide adducts, alkylnaphthol ethylene oxide adducts, phenol ethylene oxide adducts, naphthol ethylene oxide adducts, fatty acid ethylene oxide adducts, polyhydric alcohol fatty acid ester ethylene oxide adducts, higher alkylamine ethylene oxide adducts, fatty acid amide ethylene oxide adducts, ethylene oxide addacts of fat, polypropylene glycol ethylene oxide adducts, dimethylsiloxane-etnylene oxide block copolymers, dimethylsiloxane-(propylene oxide-ethylene oxide) block copolymers, fatty acid esters of polyhydric alcohol type glycerol, fatty acid esters of pentaerythritol, fatty acid esters of sorbitol and sorbitan, fatty acid esters of sucrose, alkyl ethers of polyhydric alcohols and fatty acid amides of alkanolamines. Of the compounds, those having an aromatic ring and an ethylene oxide chain are preferred, and alkyl-substituted or unsubstituted phenol ethylene oxide adducts and alkyl-substituted or unsubstituted naphthol ethylene oxide adducts are more preferred.

The amphoteric surfactant for use in the developer is not particularly limited and includes, for example, amine oxide type, for example, alkyldimethylamine oxide, betaine type, for example, alkyl betaine and amino acid type, for example, sodium salt of alkylamino fatty acid.

In Particular, an alkyldimethylamine oxide which may have a substituent, an alkyl carboxy betaine which may have a substituent and an alkyl sulfo betaine which may have a substituent are preferably used. Specific examples thereof include compounds represented by formula (2) in Paragraph No. [0256] of JP-A-2008-203359, compounds represented by formulae (I), (II) and (VI) in Paragraph No. [0028] of JP-A-2008-276166 and compounds described in Paragraph Nos. [0022] to [0029] of JP-A-2009-47927.

Two or more kinds of the surfactant may be used in combination. The content of the surfactant in the developer is preferably from 0.01 to 20% by weight, and more preferably from 0.1 1 to 10% by weight.

To the developer according to the invention is preferably further added a water-soluble polymer compound having a film-forming property other than the water-soluble polymer compound of specific structure for the purpose of protecting the surface of lithographic printing plate from the occurrence of scratches.

The water-soluble polymer compound other than the water-soluble polymer compound of specific structure includes, for example, gum arabic, a cellulose derivative (for example, carboxymethyl cellulose, carboxyethyl cellulose, methyl cellulose, hydroxypropyl cellulose or methyl propyl cellulose) or a modified product thereof, polyvinyl alcohol or a derivative thereof. polyvinyl pyrrolidone, polyacrylamide, a vinyl methyl ether/maleic anhydride copolymer, a vinyl acetate/maleic anhydride copolymer, a styrene/maleic anhydride copolymer, a starch derivative (for example, dextrin, maltodextrin, enzyme-decomposed dextrin, hydroxypropylated starch, hydroxypropylated starch enzyme-decomposed dextrin, carboxymethylated starch, phosphorylated starch or cyclodextrin), pllulan and a pllulan derivative.

Further, other starch derivative which can be used as the water-soluble polymer compound includes, for example, roast starch, for example, British gum, an enzymatically modified dextrin, for example, enzyme dextrin or Shardinger dextrin, oxidized starch, for example, solubilized starch, alphalized starch, for example, modified alphalized starch or unmodified alphalized starch, esterified starch, for example, starch phosphate, starch of fatty acid, starch sulfate, starch nitrate, starch xanthate or starch carbamate, etherified starch, for example, carboxyalkyl starch, hydroxyalkyl starch, sulfoalkyl starch, cyanoethyl starch, allyl starch, benzyl starch, carbamylethyl starch or dialkylamino starch, crosslinked starch, for example, methylol crosslinked starch, hydroxyalkyl crosslinked starch, phosphoric acid crosslinked starch or dicarboxylic acid crosslinked starch, and starch graft polymer, for example, starch-polyacrylamide copolymer, starch-polyacrylic acid copolymer, starch-polyvinyl acetate copolymer, starch-polyacrylonitrile copolymer, cationic starch-polyacrylate copolymer, cationic starch-vinyl polymer copolymer, starch-polystyrene-maleic acid copolymer, starch-polyethylene oxide copolymer or starch-polypropylene copolymer.

A natural polymer compound which can be used as the water-soluble polymer compound includes, for example, a water-soluble soybean polysaccharide, a starch, for example, starch, gelatin, hemicellulose extracted from soybean, sweet potato starch, potato starch, tapioca starch, wheat starch or corn starch, a polymer obtained from seaweed, for example, carrageenan, larninaran, seaweed mannan, funori, Irish moss, agar or sodium alginate, plant mucilage, for example, of tororoaoi, mannan, quince seed, pectin, tragacanth gum, karaya gum, xanthine gum, guar bean gum, locust bean gum, carob gum or benzoin gum, bacteria mucilage, for example, of homopolysaccharide, e.g., dextran, glucan or levan or of heteropolysaccharide, e.g., succinoglucan or xanthan gum, and protein, for example, glue, gelatin, casein or collagen.

Among them, for example, gum arabic, a starch derivative, for example, dextrin or hydroxypropyl starch, carboxymethyl cellulose or soybean polysaccharide is preferably used.

The content of the water-soluble polymer compound other than the water-soluble polymer compound of specific structure in the developer is preferably from 0.05 to 15% by weight, and more preferably from 0.5 to 10% by weight.

Into the developer for use in the invention, it is also preferable that a pH buffer agent is further be incorporated. As the pH buffer agent, a pH buffer agent exhibiting a pH buffer function at pH of 2 to 11 is preferably used without particular restriction. In the invention, a weak alkaline buffer agent is preferably used and includes, for example, (a) a carbonate ion and a hydrogen carbonate ion, (b) a borate ion, (c) a water-soluble amine compound and an ion of the amine compound, and a combination thereof. Specifically, for example, (a) a combination of a carbonate ion and a hydrogen carbonate ion, (b) a borate ion, or (c) a combination of a water-soluble amine compound and an ion of the amine compound is preferably used. The pH buffer agent exhibits a pH buffer function in the developer to prevent fluctuation of the pH even when the developer is used for a long period of time. As a result, for example, the deterioration of developing property resulting from the fluctuation of pH and the occurrence of development scum are restrained. In the invention the combination of a carbonate ion and a hydrogen carbonate ion is particularly preferred.

In order for a carbonate ion and a hydrogen carbonate ion to be present in the developer, a carbonate and a hydrogen carbonate may be added to the developer or a carbonate ion and a hydrogen carbonate ion may be generated by adding a carbonate or a hydrogen carbonate to the developer and then adjusting the pH. The carbonate or hydrogen carbonate used is not particularly restricted and it is preferably an alkali metal salt thereof Examples of the alkali metal include lithium, sodium and potassium and sodium is particularly preferred. The alkali metals may be used individually or in combination of two or more thereof.

The total amount of the carbonate ion and hydrogen carbonate ion is preferably from 0.05 to 5 mole/1, more preferably from 0.07 to 2 mole/l, particularly preferably from 0.1 to 1 mole/l, in the developer.

According to the invention, a combination of a water-soluble amine compound and an ion of the amine compound is also preferably used.

The water-soluble amine compound is not particularly restricted and preferably a water-soluble amine having a group capable of facilitating water solubility. The group capable of facilitating water solubility includes, for example, a carboxylic acid group, a sulfonic acid group, a sulfinic acid group, a phosphonic acid group and a hydroxy group. The water-soluble amine may have two or more groups capable of facilitating water solubility. Further, the carboxylic acid group, sulfonic acid group, sulfinic acid group or phosphonic acid group may form a salt structure. Among them, an amine compound having a hydroxy group is particularly preferred.

Specific examples of the water-soluble amine compound having a carboxylic acid group, a sulfonic acid group or a sulfinic acid group include an amino acid, for example, glycine, iminodiacetic acid, lysine, threonine, serine, asparaginic acid, parahydroxyphenyl glycine, dihydroxyethyl glycine, alanine, anthranilic acid or tryptophan, sulfamic acid, cyclohexylsulfamic acid, an aliphatic amine sulfonic acid, for example, taurine, an aliphatic amine sulfinic acid, for example, aminoethanesulfinic acid, and a sodium salt, potassium salt or ammonium salt thereof. Among them, glycine or iminodiacetic acid is preferred.

Specific examples of the water-soluble amine compound having a phosphonic acid group (including a phosphinic acid group) include 2-aminoethylphosphonic acid, 1-aminoethane-1,1-diphosphonic acid, 1-amino-1-phenylmethane-1,1-diphosphonic acid, 1-dimethylaminoethane-1,1-diphosphonic acid, ethylenediaminopentamethylenephosphonic acid, and a sodium salt, potassium salt or ammonium salt thereof Among them, 2-aminoethylphosphonic acid or a salt thereof is preferred.

Specific examples of the water-soluble amine compound having a hydroxy group include monoethanol amine, diethanol amine, trimethanol amine, N-hydroxyethylmorpholine, monoisopropanol amine, diisoprppanol amine, triisopropanol amine and N,N-diethanolaniline. Among them, monoethanol amine, diethanol amine, triethanol amine or N-hydroxyethylmorpholine is preferred.

The ion of the water-soluble amine compound may be generated in an aqueous solution of the water-soluble amine compound. To the aqueous solution of the water-soluble amine compound may be added an alkali or an acid. Alternatively, the ion of the water-soluble amine compound may be contained in an aqueous solution by adding a compound which is a salt of the water-soluble amine compound per se.

As the alkali, for example, sodium hydroxide, potassium hydroxide, lithium hydroxide, sodium carbonate, potassium carbonate, ammonium carbonate, sodium hydrogen carbonate, potassium hydrogen carbonate, ammonium hydrogen carbonate, or a combination thereof is used. As the acid, for example, an inorganic acid, for example, hydrochloric acid, sulfuric acid, a nitric acid or phosphoric acid is used, and particularly hydrochloric acid or phosphoric acid is preferred. By adding such an alkali or acid, the pH can be finely adjusted.

The total amount of the water-soluble amine compound and ion of the amine compound is preferably from 0.5 to 20% by weight, more preferably from 1 to 15% by weight, particularly preferably from 1 to 12% by weight, based on the weight of the developer.

The developer according to the invention may contain an organic solvent. As the organic solvent capable of being contained, for example, an aliphatic hydrocarbon (e.g., hexane, heptane, Isopar E, Isopar H, Isopar G (produced by Esso Chemical Co., Ltd.)), an aromatic hydrocarbon (e.g., toluene or xylene), a halogenated hydrocarbon (methylene dichloride, ethylene dichloride, trichlene or monochlorobenzene) or a polar solvent is exemplified. Examples of the polar solvent include an alcohol (e.g., methanol, ethanol, propanol, isopropanol, 1-butanol, 1-pentanol, 1-hexanol, 1-heptanol, 1-octanol, 2-octanol, 2-ethyl-1-hexanol, 1-nonanol, 1-decanol, benzyl alcohol, ethylene glycol monomethyl ether, 2-ethyoxyethanal, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, propylene glycol monophenyl ether, methyl phenyl carbinol, n-amyl alcohol or methylamyl alcohol), a ketone (e.g., acetone, methyl ethyl ketone, ethyl butyl ketone, methyl isobutyl ketone or cyclohexanone), an ester (e.g., ethyl acetate, propyl acetate, butyl acetate, amyl acetate, benzyl acetate, methyl lactate, butyl lactate, ethylene glycol monobutyl acetate, polyethylene glycol monomethyl ether acetate, diethylene glycol acetate, diethyl phthalate or butyl levulinate) and others (e.g., triethyl phosphate, tricresyl phosphate, N-phenylethanolamine, N-phenyldiethanolarnine, N-methyldiethanolamine, N-ethyldiethanolamine, 4-(2-hydroxyethyl)morpholine, N,N-dimethylacetamide or N-methylpyrrolidone).

Two or more organic solvents may be used in combination in the developer. When the organic solvent is insoluble in water, it may be employed by being solubilized in water using a surfactant or the like. The concentration of the organic solvent is desirably less than 40% by weight, preferably less than 10% by weight, more preferably less than 5% by weight, in view of safety and inflammability.

The developer may contain a preservative, a chelating agent, a defaming agent, an organic acid, an inorganic acid, an inorganic salt or the like in addition the components described above, Specifically, compounds described in Paragraph Nos. [0266] to [0270] of JP-A-2007-206217 are preferably used.

The developer can be used as a developer and as necessary, a development replenisher for the exposed negative type lithographic printing plate precursor. The developer can be preferably applied to the automatic development processor described above. In the case of conducting the development processing using an automatic development processor, the developer becomes fatigued in accordance with the processing amount, and hence the processing ability may be restored using a replenisher or a fresh developer.

In the method of preparing a lithographic printing plate according to the invention, the lithographic printing plate precursor may be heated its entire surface before the exposure, during the exposure or between the exposure and the development, if desired. By the heating, the image- forming reaction in the photosensitive layer is accelerated and advantages, for example, improvement in the sensitivity and printing durability and stabilization of the sensitivity are achieved. For the purpose of increasing the image strength and printing durability, it is also effective to perform entire heating or entire exposure of the image after the development. Ordinarily, the heating before the development is preferably performed under a mild condition of 150°C or lower. When the temperature is too high, a problem may arise sometimes in that the unexposed area is also cured. On the other hand, the heating after the development can be performed using very strong conditions and is ordinarily carried out in a temperature range of 100 to 500°C. When the temperature is too low, a sufficient effect of strengthening the image may not be obtained, whereas when it is excessively high, problems of deterioration of the support and thermal decomposition of the image area may occur sometimes.

### EXAMPLES

The present invention will be described in more detail with reference to the following examples, but the invention should not be construed as being limited thereto.

### Examples 1 to 25 and Comparative Examples 1 to 3

### (preparation of Support 1)

An aluminum plate (material: 1050, refining: H16) having a thickness of 0.24 mm was immersed in an aqueous 5% by weight sodium hydroxide solution maintained at 65°C to conduct a degreasing treatment for one minute, followed by washed with water. The aluminum plate was immersed in an aqueous 10% by weight hydrochloric acid solution maintained at 25°C for one minute to neutralize, followed by washed with water. Subsequently, the aluminum plate was subjected to an electrolytic surface-roughening treatment with alternating current under condition of current density of 100 A/dm² in an aqueous 0.3% by weight hydrochloric acid solution at 25°C for 60 seconds and then subjected to a desmut treatment in an aqueous 5% by weight sodium hydroxide solution maintained at 60°C for 10 seconds. The aluminum plate was subjected to an anodizing treatment under condition of current density of 10 A/dm² and voltage of 15 V in an aqueous 15% by weight sulfuric acid solution at 25°C for one minute and then subjected to a hydrophilizing treatment using an aqueous 1% by weight polyvinyl phosphonic acid solution at 75°C to prepare Support 1. The surface roughness of the support was measured and found to be 0.44 µm (Ra indication according to JIS B0601).

### (preparation of Support 2)

An aluminum plate (material: 1050, refining: H16) having a thickness of 0.3 mm was immersed in an aqueous 10% by weight sodium hydroxide solution at 60°C for 25 seconds to effect etching, washed with running water, neutralized and cleaned with an aqueous 20% by weight nitric acid solution and then washed with water. The aluminum plate was subjected to an electrolytic surface roughening treatment in an aqueous 1 % by weight nitric acid solution using an alternating current with a sinusoidal waveform at an anode time electricity of 300 coulomb/dm²*.* Subsequently, the aluminum plate was immersed in an aqueous 1% by weight sodium hydroxide solution at 40°C for 5 seconds, immersed in an aqueous 30% by weight sulfuric acid solution at 60°C for 40 seconds to effect a desmut treatment, and then subjected to an anodizing treatment in an aqueous 20% by weight sulfuric acid solution for 2 minutes under condition of current density of 2 A/dm² to form an anodic oxide film having a thickness of 2.7 g/m².The surface roughness of the aluminum plate was measured and found to be 0.28 µm (Ra indication according to JIS B0601).

On the aluminum plate thus-treated was coated Undercoat layer solution (1) shown below using a bar coater, followed by drying at 80°C for 20 seconds to prepare Support 2. The coating amount of the undercoat layer after drying was 20 mg/m2.

### <Undercoat layer solution (1)>

| | |
|---|---|
| Sol solution shown below | 100 g |
| Methanol | 900 g |

### (Sol Solution)

| | |
|---|---|
| PHOSMER PE (produced by Uni-Chemical Co., Ltd.) having structure shown below | 5 g |
| Methanol | 45 g |
| Water | 10 g |
| Phosphoric acid (85% by weight) | 5 g |
| Tetraethoxysilane | 20 g |
| 3-Methacryloxypropyltrimethoxysilane | 15 g |

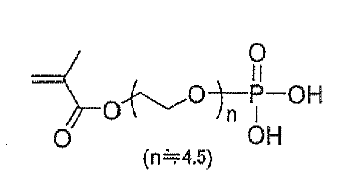

### (Preparation of Support 3)

An aluminum plate (material: JIS A1050) having a thickness of 0.3 mm was subjected to a degrease treatment with an aqueous 10% by weight sodium aluminate solution at 50°C for 30 seconds in order to remove rolling oil on the surface thereof. Thereafter, the aluminum plate surface was grained using three nylon brushes implanted with bundled bristles having a diameter of 0.3 mm and an aqueous suspension (having specific gravity of 1.1 g/cm³) of pumice having a median diameter of 25 µm, and then thoroughly washed with water.The aluminum plate was etched by immersing it in an aqueous 25% by weight sodium hydroxide solution at 45°C for 9 seconds and after washing with water, immersed in an aqueous 20% by weight nitric acid solution at 60°C for 20 seconds, followed by washing with water. The etching amount of the grained surface was about 3 g/m².

Subsequently, the aluminum plate was subjected to a continuous electrochemical surface-roughening treatment using alternate current voltage of 60 Hz. The electrolytic solution used was an aqueous 1% by weight nitric acid solution (containing 0.5% by weight of aluminum ion) at a liquid temperature of 50°C. The electrochemical surface-roughening treatment was performed using a rectangular wave alternate current having a trapezoidal waveform such that the time TP necessary for the current value to reach the peak from zero was 0.8 msec and the duty ratio was 1:1, and disposing a carbon electrode as the counter electrode. The auxiliary anode used was ferrite. The current density was 30 A/dm² in terms of the peak value of current, and 5% of the current flowing from the power source was divided to the auxiliary anode. The quantity of electricity at the nitric acid electrolysis was 175 C/dm² when the aluminum plate was serving as the anode. Then, the aluminum plate was washed with water by spraying.

Then, the aluminum plate was subjected to an electrochemical surface-roughening treatment in the same manner as in the nitric acid electrolysis described above using, as the electrolytic solution, an aqueous 0.5% by weight hydrochloric acid solution (containing 0.5% by weight of aluminum ion) at a liquid temperature of 50°C under the condition that the quantity of electricity was 50 C/dm² when the aluminum plate was serving as the anode, and then washed with water by spraying. The aluminum plate was then treated in an aqueous 15% by weight sulfuric acid solution (containing 0.5% by weight of aluminum ion) as the electrolytic solution at a current density of 15 A/dm² to provide a direct current anodic oxide film of 2.5 g/m², thereafter washed with water and dried. Then, the aluminum plate was treated with an aqueous 1% by weight sodium silicate solution at 20°C for 10 seconds. The surface roughness of the aluminum plate was measured and found to be 0.54 µm (Ra indication according to JIS B0601).

On the aluminum plate thus-treated was coated Undercoat layer solution (2) shown below using a bar coater, followed by drying at 80°C for 20 seconds to prepare Support 3. The coating amount of the undercoat layer after drying was 5 mg/m².

### <Undercoat layer solution (2)>

| | |
|---|---|
| Undercoat Compound (1) (weight average molecular weight: 50,000) shown below | 0.017 g |
| Methanol | 9.00 g |
| Water | 1.00 g |

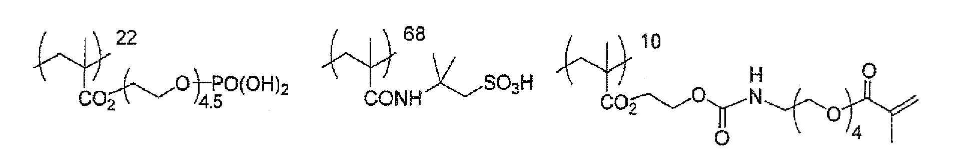

### Undercoat Compound (1)

### (Formation of Photosensitive layer 1)

Coating solution (1) for photosensitive layer having the composition shown below was coated on a support using a bar and dried in an oven at 90°C for 60 seconds to form a photosensitive layer having a dry coating amount of 1.3 g/m².

### <Coating solution (1) for photosensitive layer>

| | |
|---|---|
| Binder Polymer (1) (weight average molecular weight: 50,000) shown below | 0.34 g |
| Polymerizable Compound (1) shown below | 0.68 g |
| (PLEX 6661-0, produced by Degussa Japan Co., Ltd.) | |
| Sensitizing Dye (1) shown below | 0.06 g |
| Polymerization Initiator (1) shown below | 0.18 g |
| Chain Transfer Agent (1) shown below | 0.02 g |
| Dispersion of ε-phthalocyanine pigment | 0.40 g |
| (pigment: 15 parts by weight; dispersing agent (allyl | |
| methacrylate/methacrylic acid copolymer (weight average | |
| molecular weight: 60,000, copolymerization molar ratio: | |
| 83/17)): 10 parts by weight; cyclohexanone: 15 parts by | |
| weight) | |
| Thermal polymerization inhibitor | 0.01 g |
| N-Nitrosophenylhydroxylamine aluminum salt | |
| Fluorine-Based Surfactant (1) (weight average molecular weight: 10,000) shown below | 0.001 g |
| Polyoxyethylene-polyoxypropylene condensate | 0.02 g |
| (PLURONIC L44, produced by ADEKA Corp.) | |
| Dispersion of yellow pigment | 0.04 g |
| (yellow pigment (NOVOPERM YELLOW H2G, produced | |
| by Clariant Corp.): 15 parts by weight; dispersing agent | |
| (allyl methacrylate/methacrylic acid copolymer (weight | |
| average molecular weight: 60,000, copolymerization molar | |
| ratio: 83/17)): 10 parts by weight; cyclohexanone: 15 parts | |
| by weight) | |
| 1-Methoxy-2-propanol | 3.5 g |
| Methyl ethyl ketone | 8.0 g |

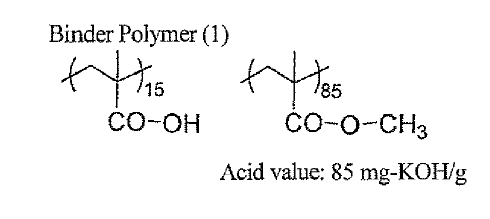

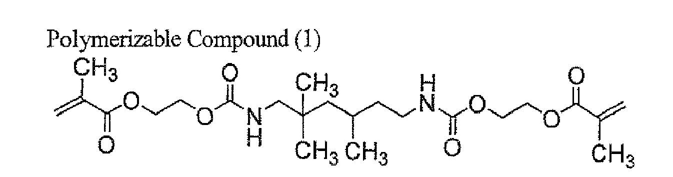

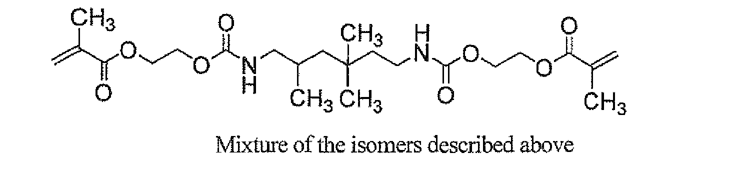

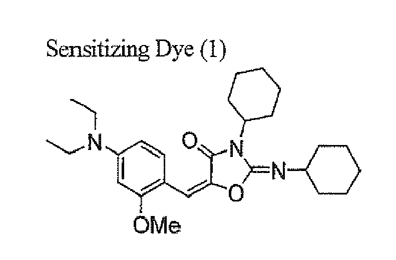

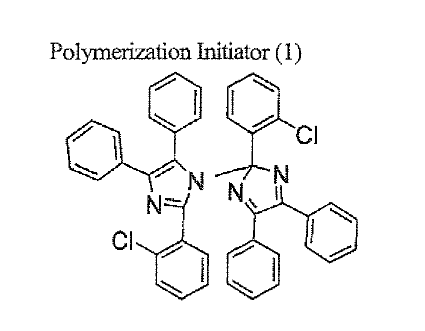

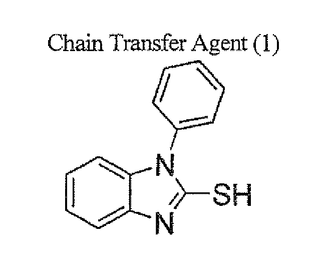

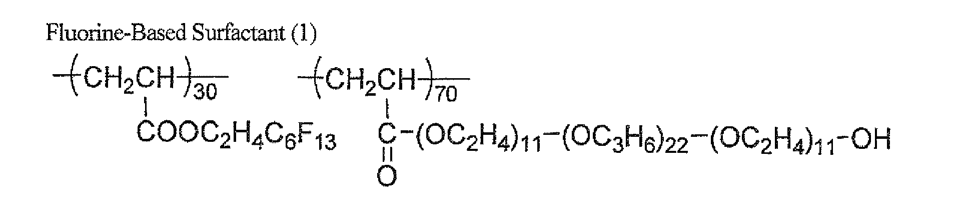

### (Formation of Photosensitive layer 2)

Coating solution (2) for photosensitive layer having the composition shown below was coated on a support using a bar and dried in an oven at 125°C for 34 seconds to form a photosensitive layer having a dry coating amount of 1.4 g/m².

### <Coating solution (2) for photosensitive layer>

| | |
|---|---|
| Infrared Absorbing Agent (IR-1) shown below | 0.038 g |
| Polymerization Initiator A (S-1) shown below | 0.061 g |
| Polymerization Initiator B (I-1) shown below | 0.094 g |
| Chain Transfer Agent (1) shown above | 0.015 g |
| Ethylenically Unsaturated Compound (M-1) shown below (A-BPE-4, produced by Shin-Nakamura Chemical Co., Ltd.) | 0.425 g |
| Binder Polymer A (B-1) (weight average molecular weight: 110,000) shown below | 0.311 g |
| Binder Polymer B (B-2) (weight average molecular weight: 100,000) shown below | 0.25 g |
| Binder Polymer C (B-3) (weight average molecular weight: 120,000) shown below | 0.062 g |
| Polyoxyethylene-polyoxypropylene condensate | 0.010 g |
| (PLURONIC L44, produced by ADEKA Corp.) | |
| Additive (T-1) shown below | 0.079 g |
| Polymerization Inhibitor (Q-1) shown below | 0.0012 g |
| Ethyl Violet (EV-1) shown below | 0.021 g |
| Fluorine-Based Surfactant (1) (weight average molecular weight: 10,000) shown above | 0.0081 g |
| Methyl ethyl ketone | 5.886 g |
| Methanol | 2.733 g |
| 1-Methoxy-2-propanol | 5.886 g |

In the formulae below, Me indicates a methyl group. The ratio of each monomer unit in Binder Polymers A to C shown below is indicated as a molar ratio.

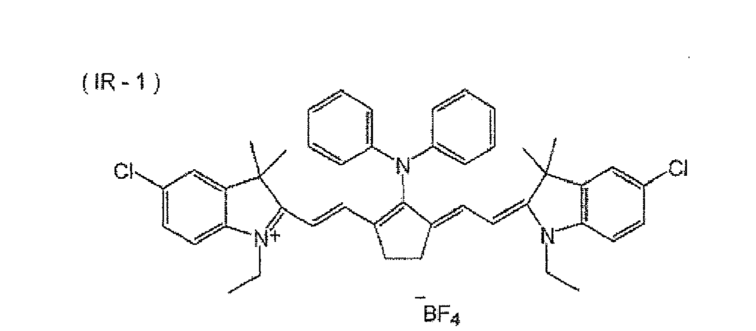

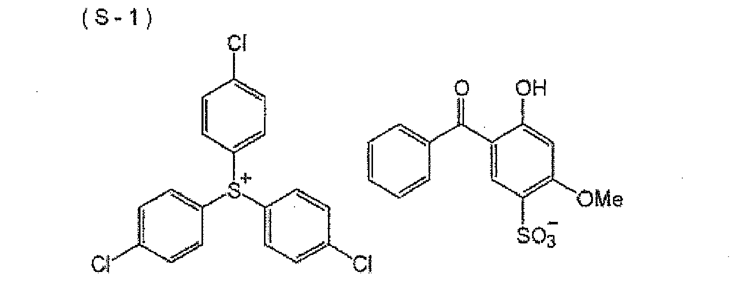

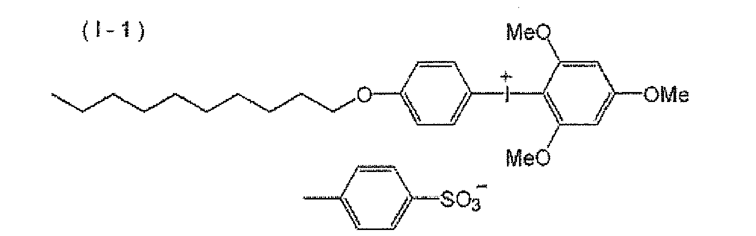

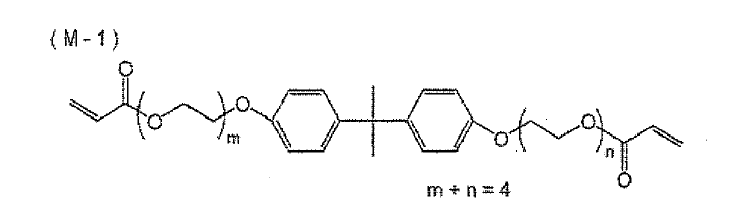

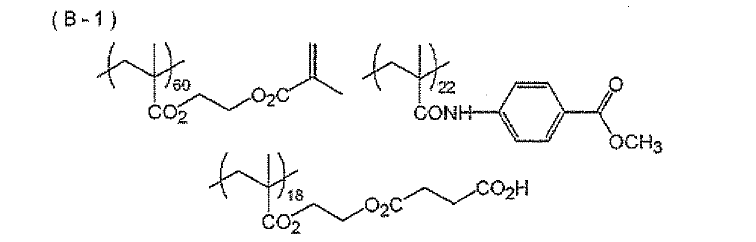

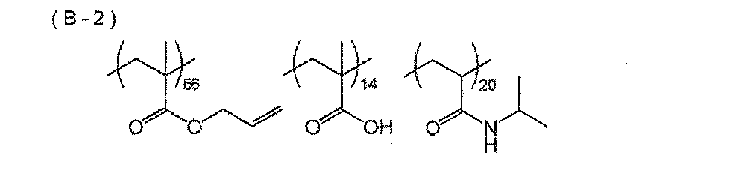

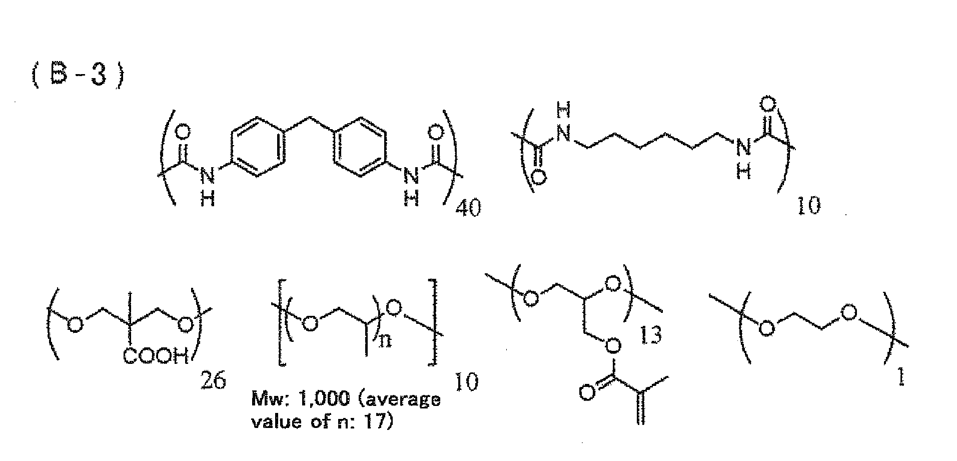

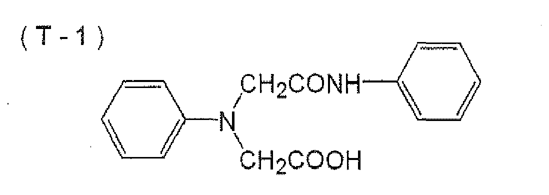

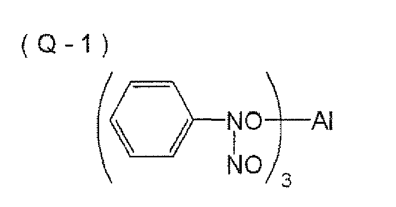

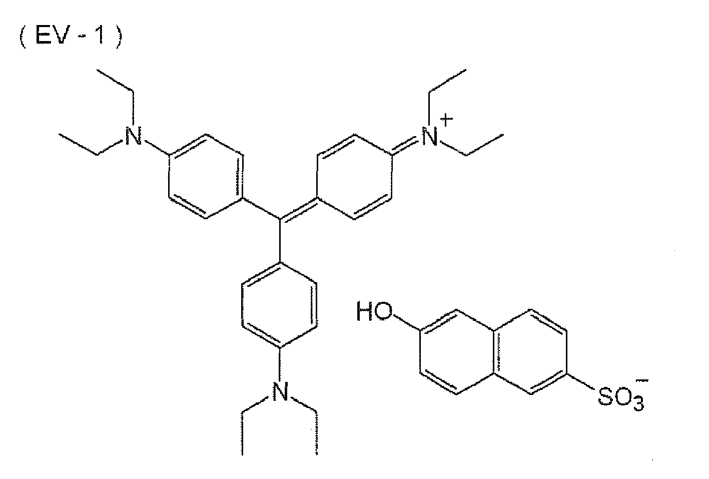

### (Formation of Photosensitive layer 3)

Coating solution (3) for photosensitive layer having the composition shown below was coated on a support using a bar and dried in an oven at 90°C for 60 seconds to form a photosensitive layer having a dry coating amount of 1.3 g/m².

### <Coating solution (3) for photosensitive layer>

| | |
|---|---|
| Binder Polymer (1) (weight average molecular weight: 50,000) shown above | 0.04 g |
| Binder Polymer (2) (weight average molecular weight: 80,000) shown below | 0.30 g |
| Polymerizable Compound (1) shown above | 0.17 g |
| (PLEX 6661-0, produced by Degussa Japan Co., Ltd.) | |
| Polymerizable Compound (2) shown below | 0.51 g |
| Sensitizing Dye (2) shown below | 0.03 g |
| Sensitizing Dye (3) shown below | 0.015 g |
| Sensitizing Dye (4) shown below | 0.015 g |
| Polymerization Initiator (1) shown above | 0.13 g |
| Chain Transfer Agent | 0.01 g |
| Mercaptobenzothiazole | |
| Dispersion of ε-phthalocyanine pigment | 0.40 g |
| (pigment: 15 parts by weight; dispersing agent (allyl | |
| methacrylate/methacrylic acid copolymer (weight average | |
| molecular weight: 60,000, copolymerization molar ratio: | |
| 83/17)): 10 parts by weight; cyclohexanone: 15 parts by | |
| weight) | |
| Thermal polymerization inhibitor | 0.01 g |
| N-Nitrosophenylhydroxylamine aluminum salt | |
| Fluorine-Based Surfactant (1) (weight average molecular weight: 10,000) shown above | 0.001 g |
| 1-Methoxy-2-propanol | 3.5 g |
| Methyl ethyl ketone | 8.0 g |

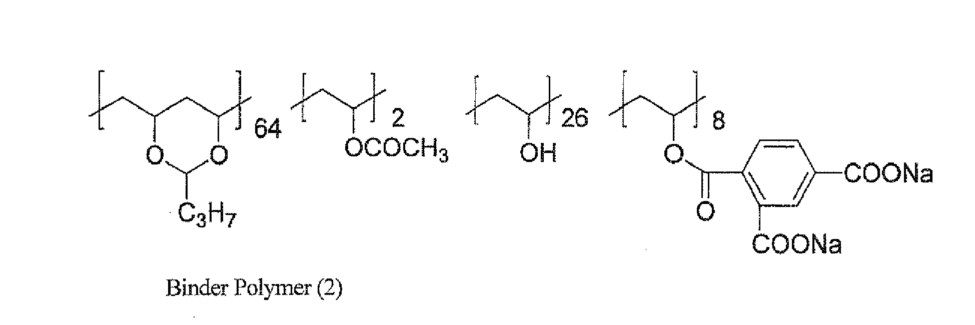

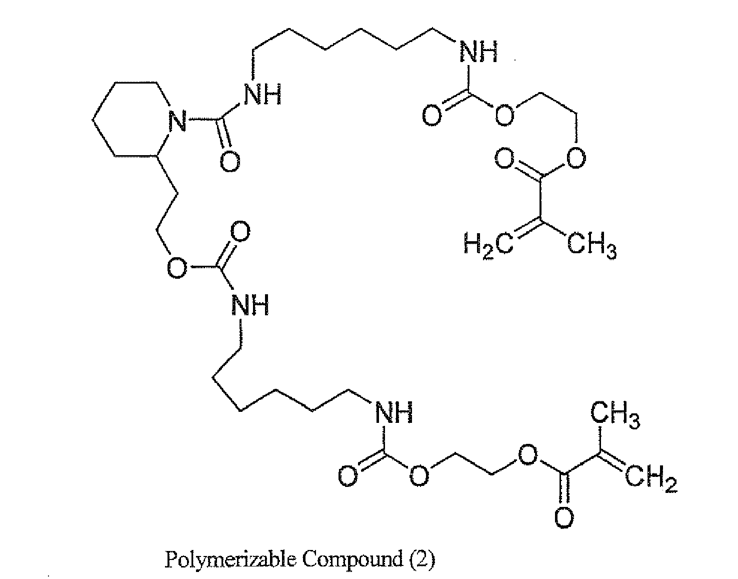

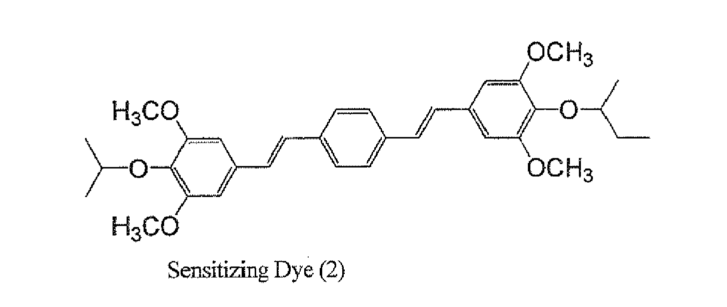

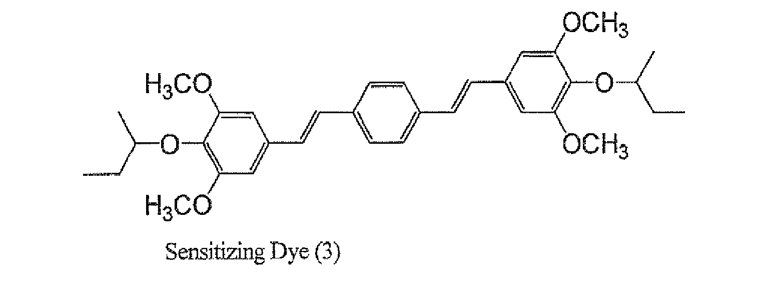

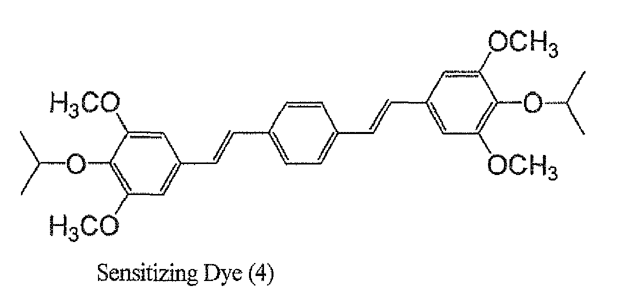

### (Formation of Protective layer 1>

Coating solution (1) for protective layer having the composition shown below was coated on a photosensitive layer using a bar so as to have a dry coating amount of 1.5 g/m² and dried at 125°C for 70 seconds to form a protective layer.

### <Coating solution (1) for protective layer>

| | |
|---|---|
| Dispersion of mica (1) shown below | 0.6 g |
| Sulfonic acid-modified polyvinyl alcohol (GOSERAN CKS-50,produced by Nippon Synthetic Chemical Industry Co., Ltd. (saponification degree: 99% by mole; average polymerizationdegree: 300; modification degree: about 0.4% by mole)) | 0.8 g |
| Vinyl pyrrolidone/vinyl acetate (1/1) copolymer (weight averagemolecular weight: 70,000) | 0.001 g |
| Surfactant (EMALEX 710, produced by Nihon Emulsion Co., Ltd.) | 0.002 g |
| Water | 13 g |

### preparation of Dispersion of mica (1))

In 368 g of water was added 32 g of synthetic mica (SOMASIF ME-100, produced by CO-OP Chemical Co., Ltd., aspect ratio: 1,000 or more) and the mixture was dispersed using a homogenizer until the average particle diameter (measured by a laser scattering method) became 0.5 µm to obtain Dispersion of mica (1).

### (Formation of Protective layer 2>

Coating solution (2) for protective layer having the composition shown below was coated on a photosensitive layer using a bar so as to have a dry coating amount of 1.2 g/m² and dried at 125°C for 70 seconds to form a protective layer.

### <Coating solution (2) for protective layer>

| | |
|---|---|
| PVA-205 (partially hydrolyzed polyvinyl alcohol, produced by Kuraray Co., Ltd. (saponification degree: 86.5 to 89.5% by mole,viscosity: 4.6 to 5.4 mPas in a 4% by weight aqueous solution at 20°C)) | 0.658 g |
| PVA-105 (fully hydrolyzed polyvinyl alcohol, produced by Kuraray Co., Ltd. (saponification degree: 98.0 to 99.0% by mole, viscosity: 5.2 to 6.0 mPas in a 4% by weight aqueous solution at 20°C)) | 0.142 g |
| Vinyl pyrrolidone/vinyl acetate (1/1) copolymer (weight average molecular weight: 70,000) | 0.001 g |
| Surfactant (EMALEX 710, produced by Nihon Emulsion Co., Ltd.) | 0.002 g |
| Water | 13 g |

### (1) Exposure, Development Processing and Printing

Each of lithographic printing plate precursors prepared by using the supports, photosensitive layers and protective layers described above in combination as shown in Table D below was subjected to image exposure by Violet semiconductor laser plate setter Vx9600 (having InGaN semiconductor laser (emission wavelength: 405 nm ± 10 nm/output: 30 mW)) produced by FUJIFILM Electronic Imaging Ltd. The image exposure was performed at resolution of 2,438 dpi with halftone dots of 50% using FM screen (TAFFETA 20, produced by FUJIFILM Corp.) in a plate surface exposure amount of 0.05 mJ/cm².

The exposed lithographic printing plate precursor was then subjected to development processing in an automatic development processor having the structure shown in Fig. 1 using Developers 1 to 24 having the composition and pH shown in Tables A to C as shown in Table D, respectively. A heater was set so as to reach the plate surface temperature at 100°C in the pre-heating unit and the development processing was conducted at a transporting speed so as to make the immersion time (developing time) in the developer for 20 seconds, thereby preparing a lithographic printing plate.

The lithographic printing plate obtained was mounted on a printing machine (SOR-M, produced by Heidelberg) and printing was performed at a printing speed of 6,000 sheets per hour using dampening water (EU-3 (etching solution, produced by FUJIFILM Corp.))/water/isopropyl alcohol = 1/89/10 (by volume ratio)) and TRANS-G (N) black ink (produced by Dainippon Ink & Chemicals, Inc.).

### (2) Evaluation

Using each of the lithographic printing plate precursors, the developing property, stain property at initial stage of printing, stain property after interruption of printing and printing durability were evaluated in the manner shown below.

### <Developing property>

The lithographic printing plate precursor was subjected to the exposure and development processing as described above. The non-image area of the lithographic printing plate obtained was visually observed and the residue of photosensitive layer was evaluated. The evaluation was conducted according to the criteria described below.

A: Residue of photosensitive layer was not observed to exhibit good developing property.

B: Although a slight residue of photosensitive layer was observed, developing property was no problem.

C: Photosensitive layer remained to cause poor development.

### <Stain property at initial stage of printing>

The lithographic printing plate was subjected to the printing as described above and stain property in the non-image area of 1,000th printed material was evaluated. The evaluation was conducted according to the criteria described below.

A: No ink stain was observed in the non-image area.

C: Ink stain was observed in the non-image area.

### <Stain property after interruption of printing>

The lithographic printing plate was subjected to the printing as described above and after printing 50,000 sheets, the printing machine was stopped and allowed to stand for 3 hours. Then, the printing was restarted to print further 200 sheets and a number of sheets until the ink disappeared in the non-image area was evaluated. When the number of sheets is smaller, the waste sheets much more decreases and it is meant that the stain property after interruption of printing is better.

### <Printing durability>

As increase in the number of printed materials, the image of the photosensitive layer formed on the lithographic printing plate was gradually abraded to cause decrease in the ink receptive property, resulting in decrease of ink density of the image on the printing paper. A number of printed materials obtained until the ink density (reflection density) decreased by 0.1 from that at the initiation of printing was determined to evaluate the printing durability.

**TABLE A (unit in grams)**

| Component | Developer | | | | | | | | | | | |
|---|---|---|---|---|---|---|---|---|---|---|---|---|
| | 1 (for Comparison) | 2 | 3 | 4 | 5 | 6 | 7 | 8 | 9 (for Comparison) | 10 | 11 | 12 |
| Water-Soluble Polymer Compound | | | | | | | | | | | | |
| (1)-a (for Comparison) | 500 | | | | | | | | | | | |
| (1)-b | | 500 | | | | | | | | | | |
| (1)-c | | | 500 | | | | | | | | | |
| (l)-d | | | | 500 | | | | | | | | |
| (1)-e | | | | | 500 | | | | | 500 | 500 | 500 |
| (1)-f | | | | | | 500 | | | | | | |
| (1)-g | | | | | | | 500 | | | | | |
| (1)-h | | | | | | | | 500 | | | | |
| (1)-i (for Comparison) | | | | | | | | | 500 | | | |
| Surfactant | | | | | | | | | | | | |
| Alkyldiphenyl Ether Disulfonate (ELEMINOL MON2, produced by Sanyo Chemical Industries, Ltd.) | | | | | | | | | | 500 | | |
| Polyoxy Naphthyl Ether (NEWCOL B13, produced Nippon Nyukazai Co., Ltd.) | | | | | | | | | | | 500 | |
| N-Lauricamido Propyl Dimethyl Betain (SOFTAZOLINE LPB-R, produced by Kawaken Fine Chemicals Co., Ltd.) | 400 | 400 | 400 | 400 | 400 | 400 | 400 | 400 | 400 | | | 400 |
| N-Lauricamido Propyl Dimethyl Amineoxide (SOFTAZOLINE LAO, | 100 | 100 | 100 | 100 | 100 | 100 | 100 | 100 | 100 | | | 100 |
| produced by Kawaken Fine Chemicals Co,, Ltd.) | | | | | | | | | | | | |
| pH Buffer Agent | | | | | | | | | | | | |
| Sodium Carbonate | 88 | 88 | 88 | 88 | 88 | 88 | 88 | | 88 | 88 | 88 | |
| Sodium Hydrogen Carbonate | 37 | 37 | 37 | 37 | 37 | 37 | 37 | 37 | 37 | 37 | 37 | |
| glethanolamine | | | | | | | | | | | | 100 |
| Triethanolamine | | | | | | | | | | | | 200 |
| Phosphoric acid | | | | | | | | | | | | Amount for adjusting pH shown below |
| Others | | | | | | | | | | | | |
| Hydroxyalkylated Starch (PENNON JE66, produced by Nippon Starch Chemical Co., Ltd.) | 150 | 150 | 150 | 150 | 150 | 150 | 150 | 150 | 150 | 150 | 150 | 150 |
| Sodium Gluconate | 50 | 50 | 50 | 50 | 50 | 50 | 50 | 50 | 50 | 50 | 50 | 50 |
| Ammonium Primary Phosphate | 20 | 20 | 20 | 20 | 20 | 20 | 20 | 20 | 20 | 20 | 20 | 20 |
| 2-Bromo-2-nitropropane-1,3-diol | 0.1 | 0.1 | 0.1 | 0.1 | 0.1 | 0.1 | 0.1 | 0.1 | 0.1 | 0.1 | 0.1 | 0.1 |
| 2-Methyl-4-isothiazolin-3-one | 0.1 | 0.1 | 0.1 | 0.1 | 0.1 | 0.1 | 0.1 | 0.1 | 0.1 | 0.1 | 0.1 | 0.1 |
| Ethylenediamine Disuccinic Acid | 20 | 20 | 20 | 20 | 20 | 20 | 20 | 20 | 20 | 20 | 20 | 20 |
| Defoaming agent (TSA 739, produced by GE Toshiba Silicones Co., Ltd.) | 2 | 2 | 2 | 2 | 2 | 2 | 2 | 2 | 2 | 2 | 2 | 2 |
| Water | 8632.8 | 8632.8 | 8932.8 | 8732.8 | 8482.8 | 8632,8 | 8632.8 | 8632.8 | 8632.8 | 8632.8 | 8457.8 | 8457.8 |
| pH of Developer | 9.8 | 9.8 | 9.8 | 9.8 | 9.8 | 9.8 | 9.8 | 9.8 | 9.8 | 9.8 | 9.8 | 6.9 |

Water-soluble polymer compounds (1)-a to (1)-i described above are polymers having a weight average molecular weight of 120,000 and containing the repeating units shown below in the ratio (% by mole) shown below, respectively.

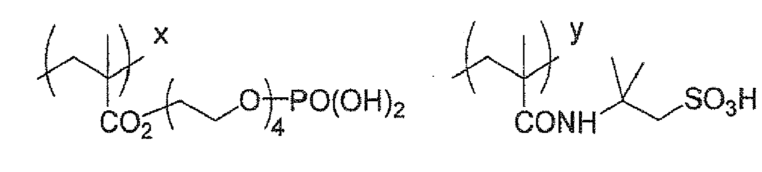

| Water-Soluble Polymer Compound | x/y Ratio |
|---|---|
| (1)-a (for Comparison) | 0/100 |
| (1)-b | 2/98 |
| (1)-c | 5/95 |
| (1)-d | 10/90 |
| (1)-e | 25/75 |
| (1)-f | 50/50 |
| (1)-g | 60/40 |
| (1)-h | 70/30 |
| (1)-i (for Comparison) | 100/0 |

**TABLE B (unit in grams)**

| Component | Developer | | | |
|---|---|---|---|---|
| | 13 (for Comparison) | 14 | 15 | 16 |
| Water-Soluble Polymer Compound (1)-e | 0 | 50 | 200 | 1,000 |
| Components Other Than Above | Same as in Developer 4 | | | |
| pH of Developer | 9.8 | 9.8 | 9.8 | 9.8 |

**TABLE C (unit in grams)**

| Component | | Developer | | | | | | | |
|---|---|---|---|---|---|---|---|---|---|
| | | 17 | 18 | 19 | 20 | 21 | 22 | 23 | 24 |
| Water-Soluble Polymer Compound | | | | | | | | | |
| | (2) | 500 | | | | | | | |
| | (3) | | 500 | | | | | | |
| | (4) | | | 500 | | | | | |
| | (5) | | | | 500 | | | | |
| | (6) | | | | | 500 | | | |
| | (7) | | | | | | 500 | | |
| | (8) | | | | | | | 500 | |
| | 9) | | | | | | | | 500 |
| Components Other Tan Above | | Same as in Developer 4 | | | | | | | |
| pH of Developer | | 9.8 | 9.8 | 9.8 | 9.8 | 9.8 | 9.8 | 9.8 | 9.8 |

The repeating units, ratio (% by mole) thereof and weight average molecular weight of Water-Soluble Polymer Compounds (2) to (9) are shown below, respectively.

### Water-Soluble Polymer Compound (2)

### Weight average molecular weight: 80,000

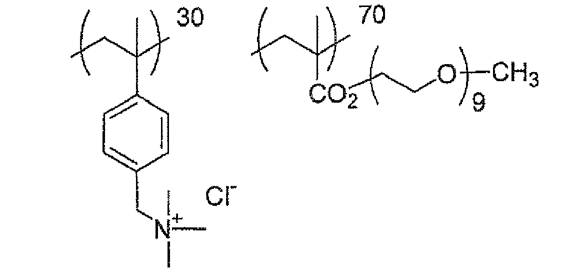

### Water-Soluble Polymer Compound (3)

### Weight average molecular weight: 50,000

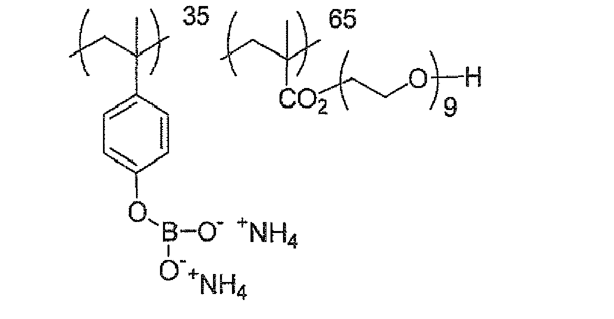

### Water-Soluble Polymer Compound (4)

### Weight average molecular weight: 100,000

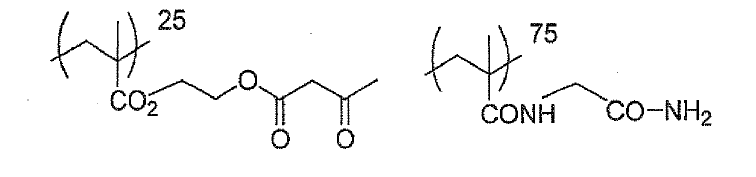

### Water-Soluble Polymer Compound (5)

### Weight average molecular weight: 120,000

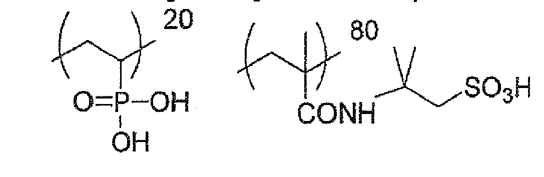

### Water-Soluble Polymer Compound (6)

### Weight average molecular weight 100,000

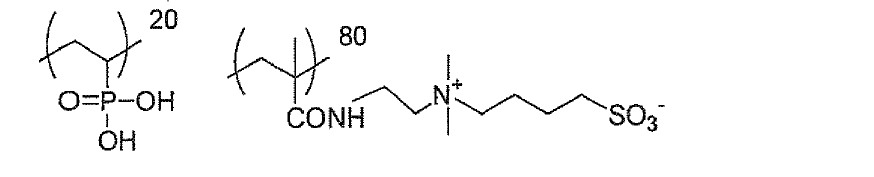

### Water-Soluble Polymer Compound (7)

### Weight average molecular weight: 140,000

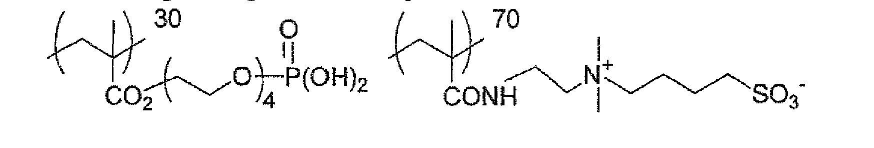

### Water-Soluble Polymer Compound (8)

### Weight average molecular weight: 120,000

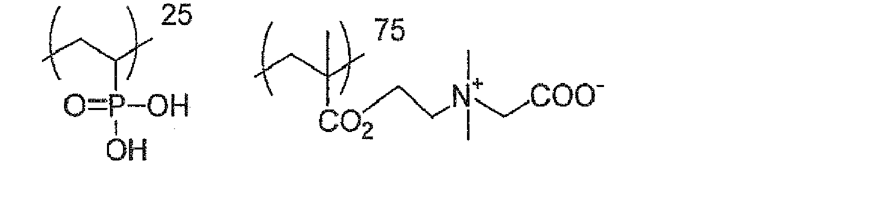

### Water-Soluble Polymer Compound (9)

### Weight average molecular weight: 180,000

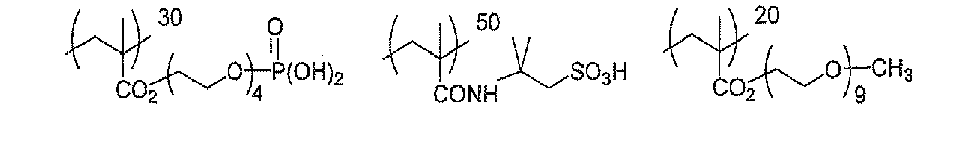

**TABLE D**

| | Support | Photosensitive Layer | Protective Layer | Developer | Developing Property | Stain Property at Initial Stage of Printing | Stain Property after interruption of Printing (number of sheets) | Printing Durability (number of sheets (x 10⁴)) |
|---|---|---|---|---|---|---|---|---|
| Example 1 | 1 | 1 | 1 | 5 | A | A | 25 | 12 |
| Example 2 | 2 | 1 | 1 | 5 | A | A | 30 | 14 |
| Comparative Example 1 | 3 | 1 | 1 | 1 | A | A | 100 | 12 |
| Examples 3 | 3 | 1 | 1 | 2 | A | A | 45 | 12 |
| Example 4 | 3 | 1 | 1 | 3 | A | A | 35 | 12 |
| Example 5 | 3 | 1 | 1 | 4 | A | A | 20 | 12 |
| Example 6 | 3 | 1 | 1 | 5 | A | A | 20 | 12 |
| Example 7 | 3 | 1 | 1 | 6 | A | A | 20 | 12 |
| Example 8 | 3 | 1 | 1 | 7 | A | A | 30 | 12 |
| Example 9 | 3 | 1 | 1 | 8 | A | A | 40 | 12 |
| Comparative Example 2 | 3 | 1 | 1 | 9 | A | A | 100 | 12 |
| Example 10 | 3 | 1 | 1 | 10 | A | A | 25 | 11 |
| Example 11 | 3 | 1 | 1 | 11 | A | A | 20 | 10 |
| Example 12 | 1 | 3 | 2 | 12 | A | A | 20 | 10 |
| Example 13 | 2 | 3 | 2 | 12 | A | A | 30 | 10 |
| Example 14 | 3 | 3 | 2 | 12 | A | A | 20 | 12 |
| Comparative Example 3 | 3 | 1 | 1 | 13 | A | A | 150 | 12 |
| Example 15 | 3 | 1 | 1 | 14 | A | A | 50 | 12 |
| Example 16 | 3 | 1 | 1 | 15 | A | A | 20 | 12 |
| Example 17 | 3 | 1 | 1 | 16 | A | A | 20 | 12 |
| Example 18 | 3 | 1 | 1 | 17 | A | A | 35 | 12 |
| Example 19 | 3 | 1 | 1 | 18 | A | A | 35 | 12 |
| Example 20 | 3 | 1 | 1 | 19 | A | A | 30 | 12 |
| Example 21 | 3 | 1 | 1 | 20 | A | A | 20 | 12 |
| Example 22 | 3 | 1 | 1 | 21 | A | A | 15 | 12 |
| Example 23 | 3 | 1 | 1 | 22 | A | A | 15 | 12 |
| Example 24 | 3 | 1 | 1 | 23 | A | A | 20 | 12 |
| Example 25 | 3 | 1 | 1 | 24 | A | A | 25 | 12 |

From the results shown in Table D, it can be seen that the method of preparing a lithographic printing plate using a developer containing the water-soluble polymer compound of specific structure according to the invention exhibits good developing property without residue of the photosensitive layer in the non-image area and provides a lithographic printing plate having good printing durability and excellent in an satin preventing property of the non-image area, even in the simple processing of one solution and one step which does not require a water washing step.

### Example 26

In the violet semiconductor laser plate setter Vx9600 produced by FUJIFILM Electronic Imaging Ltd. wherein the InGaN semiconductor laser (emission: 405 nm ± 10 nm/output: 30 mW) had been replaced with a semiconductor laser having output of 100 mW, the lithographic printing plate precursor used in Example 6 was subjected to image exposure in a plate surface exposure amount of 0.25 mJ/cm². The exposed lithographic printing plate precursor was then subjected to the development processing in the automatic development processor having a structure shown in Fig. 1 wherein the heater in the pre-heater unit was turned off (specifically, without performing the pre-heating) using Developer 5. Except as described above, the developing property, stain property at initial stage of printing, stain property after interruption of printing and printing durability were evaluated in the same manner as in Example 6 and the good results similar to those in Example 6 were obtained.

### Example 27

A lithographic printing plate precursor prepared by combination of Support 3, Photosensitive layer 2 and Protective layer 1 was subjected to image exposure with halftone dots of 50% by Trendsetter 3244VX, (produced by Creo Co.) equipped with a water-cooled 40 W infrared semiconductor laser (830 nm) under the conditions of output of 9 W, a rotational number of an external drum of 210 rpm and resolution of 2,400 dpi. The exposed lithographic printing plate precursor was subjected to development processing in an automatic development processor having the structure shown in Fig. 1 using Developer 5. A heater was set so as to reach the plate surface temperature at 100°C in the pre-heating unit and the development processing was conducted at a transporting speed so as to make the immersion time (developing time) in the developer for 20 seconds. The Evaluations of developing property, stain property at initial stage of printing, stain property after interruption of printing and printing durability were evaluated in the same manner as in Example 6. The results of evaluation were the developing property of A, the stain property at initial stage of printing of A, the stain property after interruption of printing of 20 sheets and the printing durability of 10 x 10⁴ sheets.

## Claims

1. A method of preparing a lithographic printing plate comprising:
exposing a lithographic printing plate precursor comprising, in the following order, a hydrophilic support, a photosensitive layer containing (A) a polymerization initiator, (B) a polymerizable compound, (C) a sensitizing dye and (D) a binder polymer and a protective layer with laser; and
rubbing a surface of the exposed lithographic printing plate precursor with a rubbing member in the presence of a developer having pH of from 2 to 11 and containing a water-soluble polymer compound to remove the protective layer and an unexposed area of the photosensitive layer,
wherein the water-soluble polymer compound is a vinyl copolymer containing a monomer unit having at least one functional group capable of interacting with a surface of the support and a monomer unit having at least one hydrophilic group which is different from the functional group capable of interacting with a surface of the support.

2. The method as claimed in claim 1, wherein the functional group capable of interacting with a surface of the support is at least one group selected from an onium group, a phosphoric ester group and a salt thereof, a phosphonic acid group and a salt thereof, a boric acid group and a salt thereof and a β-diketone group.

3. The method as claimed in claim 1 or 2, wherein the hydrophilic group is at least one group selected from a sulfonic acid group and a salt thereof, an amido group, a polyalkyleneoxy group and a group having a betaine structure.

4. The method as claimed in any one of claims 1 to 3, wherein a content ratio of the monomer unit having a functional group capable of interacting with a surface of the support is from 2 to 70% by mole based on a total monomer unit contained in the copolymer.

5. The method as claimed in any one of claims 1 to 4, wherein a content ratio of the monomer unit having a hydrophilic group is from 30 to 98% by mole based on a total monomer unit contained in the copolymer.

6. The method as claimed in any one of claims 1 to 5, wherein a content of the copolymer contained in the developer is from 0.1 to 20% by weight.

7. The method as claimed in any one of claims 1 to 6, wherein the developer further contains a carbonate ion and a hydrogen carbonate ion.

8. The method as claimed in any one of claims 1 to 6, wherein the developer further contains a water-soluble amine compound and an ion of the amine compound.

9. The method as claimed in any one of claims 1 to 8, wherein the developer further contains a surfactant in an amount from 0.01 to 20% by weight.

10. The method as claimed in any one of claims 1 to 9, which does not comprises a water washing step.

11. A developer for use in a method of preparing a lithographic printing plate comprising exposing a lithographic printing plate precursor comprising, in the following order, a hydrophilic support, a photosensitive layer containing (A) a polymerization initiator, (B) a polymerizable compound, (C) a sensitizing dye and (D) a binder polymer and a protective layer with laser and removing the protective layer and an unexposed area of the photosensitive layer in the presence of the developer, wherein the developer has pH of from 2 to 11 and contains a water-soluble polymer compound, and the water-soluble polymer compound is a vinyl copolymer containing a monomer unit having at least one functional group capable of interacting with a surface of the support and a monomer unit having at least one hydrophilic group which is different from the functional group capable of interacting with a surface of the support.
